# EUROPEAN PATENT APPLICATION

(11) **EP 4 746 611 A1**
(43) Date of publication of application: **20.05.2026**
(21) Application number: 25762886.7
(22) Date of filing: 27.08.2025
(51) Int. Cl.: H05K 9/00, H05K 7/20, C09K 5/14, H05K 1/02, H04M 1/02

(54) **PRINTED CIRCUIT BOARD ASSEMBLY AND ELECTRONIC DEVICE COMPRISING SAME**

(30) Priority: 27.08.2024 KR 20240115379; 29.10.2024 KR 20240149525
(71) Applicant: SAMSUNG ELECTRONICS CO., LTD., Yeongtong-gu Suwon-si, Gyeonggi-do 16677 (KR)
(72) Inventor: CHO, Hyeon, Gyeonggi-do 16677 (KR); LEE, Haejin, Gyeonggi-do 16677 (KR); AHN, Joseph, Gyeonggi-do 16677 (KR); KI, Seokkan, Gyeonggi-do 16677 (KR); KIM, Chorim, Gyeonggi-do 16677 (KR); LIM, Jonghyun, Gyeonggi-do 16677 (KR)
(74) Representative: HGF
(86) International application number: PCT/KR2025/013061
(87) International publication number: WO 2026/049496

(57) **Abstract**

An electronic device or printed circuit board assembly according to embodiments of the disclosure may include a printed circuit board on which electronic components are mounted, a shield can disposed to shield the electronic components, a composite heat dissipation structure disposed over the electronic components, and a shielding layer disposed over the composite heat dissipation structure. The electronic device may include a display disposed on the shielding film. Various other embodiments may also be possible.

## Description

### [Technical Field]

Embodiments of the disclosure relate to a printed circuit board assembly (PBA) including a heat dissipation structure, and an electronic device including the printed circuit board assembly.

### [Background Art]

The term "electronic device" may refer to (or include) a device that performs a designated function based on a program installed therein, such as a home appliance, an electronic scheduler, a portable multimedia player, a mobile communication terminal, a tablet PC, a video/audio device, a desktop/laptop PC, or a vehicle navigation system. An electronic device may include a printed circuit board (PCB) on which a processor (e.g., an application processor (AP), a central processing unit (CPU)), a memory (e.g., a DRAM), electronic components, and peripheral circuits are mounted.

The electronic device may include shielding components (e.g., shielding members) configured to shield noise (e.g., electromagnetic waves) generated from the processor, the memory, and the electronic components. The electronic device may include a heat dissipation structure configured to dissipate heat generated from the processor, the memory, and the electronic components. For example, the heat dissipation structure may include a heat dissipation material (e.g., a thermal interface material ("TIM")), a heat spreading plate, and/or a heat spreading sheet.

The above-described contents are presented as background information only to assist with an understanding of the disclosure. No determination and no assertion have been made as to whether any of the above might be applicable as prior art with regard to the disclosure.

### [Disclosure of Invention]

### [Technical Problem]

To shield noise (e.g., electromagnetic waves) generated from components of an electronic device, a frame made of a metal material (e.g., a metal plate) and a shield can surrounding a processor, a memory, and electronic components may be applied. To dissipate heat generated from the processor, the memory, and the electronic components of the electronic device, the electronic device may include a heat dissipation structure (e.g., a TIM, a heat spreading plate, and a heat spreading sheet).

In an electronic device, a processor, a memory, and electronic components having high power consumption per unit area (e.g., high power density) are applied. Because the processor, the memory, and the electronic components with high power consumption per unit area are mounted on a limited area of a printed circuit board (PCB), heat may be generated in the electronic device. As the heat generation temperature of the electronic device increases, the performance of the processor, the memory, and the electronic components may deteriorate, and the lifespan thereof may be shortened. In addition, the temperature of the external surfaces of the electronic device increases due to the increased heat generation temperature, which may be uncomfortable to a user and/or dangerous.

Generally, alumina (Al₂O₃), which is used as a non-conductive filler, may be used as a TIM for heat dissipation from the processor (e.g., an application processor). As the power generated from the processor (e.g., an application processor) continuously increases, a TIM having a higher thermal conductivity needs to be applied to effectively remove the high heat generated from the processor (e.g., an application processor). Since high electrical conductivity also means high thermal conductivity, a filler having high electrical conductivity may be used as the TIM.

A TIM with generally high thermal conductivity contains a large amount of hard conductive fillers, and thus, when excessively compressed, deformation of other components of an electronic device, for example a smartphone display and a support member (e.g., a front metal), may occur. In addition, around the processor (e.g., an application processor), various electronic elements such as a passive component, a PMIC, and an IC are arranged, and spreading of the conductive fillers may cause a short circuit.

It is necessary to fill spaces between the electronic components with the TIM to effectively transfer heat, but a hard TIM may not sufficiently fill voids present on the rough interfaces of heat-generating electronic components. As a result, parasitic heat resistance may occur, preventing full utilization of the high thermal conductivity. Although a liquid TIM or a highly compressible solid TIM may be used, the heat generated from the processor (e.g., an application processor) may not be effectively dissipated due to the low thermal conductivity of the materials included therein to ensure flexibility.

An embodiment of the disclosure may provide a printed circuit board assembly including a heat dissipation structure capable of efficiently dissipating heat generated from heat-generating components (e.g., a processor and a memory), and an electronic device including the printed circuit board assembly.

An embodiment of the disclosure may provide a printed circuit board assembly including a heat dissipation structure capable of delaying a dynamic thermal management (DTM) timing at which a performance limitation of the electronic device is performed and lowering the temperatures of processors (an application processor and a GPU), and an electronic device including the printed circuit board assembly.

The technical problems to be solved by the disclosure are not limited to the technical problems mentioned above, and various modifications may be made without departing from the spirit and scope of the disclosure. Other technical problems not mentioned herein may be clearly understood by those ordinarily skilled in the art to which the disclosure pertains based on the following description.

An electronic device according to an embodiment of the disclosure may include a printed circuit board on which electronic components are mounted. The electronic device may include a shield can disposed to shield the electronic components. The electronic device may include a composite heat dissipation structure disposed over the electronic components. The electronic device may include a shielding layer (e.g. shielding film) disposed over the composite heat dissipation structure. The electronic device may include a display disposed on the shielding layer (e.g. shielding film).

A printed circuit board assembly according to an embodiment of the disclosure may include a printed circuit board on which electronic components are mounted. The printed circuit board assembly may include a shield can disposed to shield the electronic components. The printed circuit board assembly may include a composite heat dissipation structure disposed over the electronic components. The printed circuit board assembly may include a shielding layer (e.g. shielding film) disposed over the composite heat dissipation structure.

The printed circuit board assembly including the heat dissipation structure of the disclosure, and the electronic device including the printed circuit board assembly, may efficiently dissipate heat generated from heat-generating components (e.g., a processor and a memory).

The printed circuit board assembly including the heat dissipation structure of the disclosure, and the electronic device including the printed circuit board assembly, may delay a dynamic thermal management (DTM) timing at which the maximum temperature for performance limitation of the electronic device is reached and may lower temperatures of processors (e.g., an application processor or a GPU).

A printed circuit board assembly including the composite heat dissipation structure of the disclosure, and an electronic device including the printed circuit board assembly, may be configured such that a first heat dissipation structure (e.g., an insulating heat dissipation structure) is disposed to cover an upper surface of at least some of heat-generating components (e.g., a processor and a memory), and a second heat dissipation structure (e.g., a conductive heat dissipation structure) is disposed to cover at least a portion of an upper surface of the first heat dissipation structure, thereby preventing the occurrence of a short circuit.

Since the composite heat dissipation structure according to an embodiment of the disclosure has different compressibilities between the first heat dissipation structure (e.g., the insulating heat dissipation structure) and the second heat dissipation structure (e.g., the conductive heat dissipation structure), it may be possible to prevent defects caused by compression during a manufacturing process.

The composite heat dissipation structure according to an embodiment of the disclosure applies a compressible TIM, thereby reducing thermal resistance at an interface between the heat-generating components (e.g., the processor and the memory) and the composite heat dissipation structure.

The printed circuit board assembly including the heat dissipation structure of the disclosure, and the electronic device including the printed circuit board assembly, may improve the heat dissipation performance of heat generated from the processor and the memory even under an environment where high heat generation of about 15 W occurs.

As a result of comparing the dynamic thermal management (DTM) timing at which the maximum temperature for performance limitation of the electronic device is reached and the GPU temperature, the printed circuit board assembly including the heat dissipation structure of the disclosure, and the electronic device including the printed circuit board assembly, may achieve a delay of about 54 to 58 seconds in the DTM timing and may lower a processor temperature by about -5.8°C, by applying the heat dissipation structure (#3) of the disclosure compared to comparative examples (#1 and #2).

Advantageous effects obtainable from the disclosure may not be limited to the above-mentioned effects, and other effects which are not mentioned herein may be clearly understood from the following description by those skilled in the art to which the disclosure pertains.

### [Brief Description of Drawings]

With regard to the description of the drawings, the same or like reference signs may be used to designate the same or like elements.
FIG. 1 is a block diagram of an electronic device in a network environment according to various embodiments of the disclosure;
FIGS. 2A and 2B are views illustrating a first state (e.g., an unfolded state) of an electronic device according to an embodiment of the disclosure when viewed from the front and rear.
FIGS. 2C and 2D are views illustrating a second state (e.g., a folded state) of the electronic device according to an embodiment of the disclosure when viewed from the front and rear.
FIG. 3A is a perspective view of a first surface (e.g., a front surface) of an electronic device according to an embodiment of the disclosure.
FIG. 3B is a perspective view of a second surface (e.g., a rear surface) of the electronic device according to an embodiment of the disclosure.
FIG. 4 is a view illustrating a printed circuit board assembly including a heat dissipation structure and an electronic device including the printed circuit board assembly, according to an embodiment of the disclosure.
FIGS. 5 to 7 are views illustrating a method of forming the heat dissipation structure of the printed circuit board assembly illustrated in FIG. 4.
FIG. 8 is a view illustrating a method of forming a heat dissipation structure of a printed circuit board assembly illustrated in FIG. 4.
FIG. 9 is a view illustrating a printed circuit board assembly including a heat dissipation structure and an electronic device including the printed circuit board assembly, according to an embodiment of the disclosure.
FIG. 10 is a view illustrating a printed circuit board assembly including a heat dissipation structure and an electronic device including the printed circuit board assembly, according to an embodiment of the disclosure.
FIG. 11 is a view illustrating a printed circuit board assembly including a heat dissipation structure and an electronic device including the printed circuit board assembly, according to an embodiment of the disclosure.
It should be noted that throughout the drawings, the same reference numbers are used to describe the same or similar elements, features, and structures.

### [Mode for the Invention]

The following description with reference to the accompanying drawings is provided to assist in comprehensive understanding of an embodiment of the disclosure as defined by the claims and equivalents thereof. The description includes various specific details to assist in the understanding, but the details are to be regarded merely as examples. Accordingly, those skill in the art will recognize that various changes and modifications may be made to an embodiment set forth herein without departing from the scope and spirit of the disclosure. In addition, descriptions of well-known functions and configurations may be omitted for the sake of clarity and conciseness.

The terms and words used in the following description and the claims are not limited to the bibliographical meanings thereof, but are merely used by the inventors to enable clear and consistent understanding of the disclosure. Accordingly, it will be apparent to those skilled in the art that the following description of various embodiments of the disclosure is not intended to limit the disclosure as defined by the appended claims and equivalents thereof, but is provided merely for the purpose of illustration.

It is to be understood that the expressions in singular forms include plural referents unless the context clearly dictates otherwise. Therefore, for example, reference to "a component surface" includes reference to one or more such surfaces.

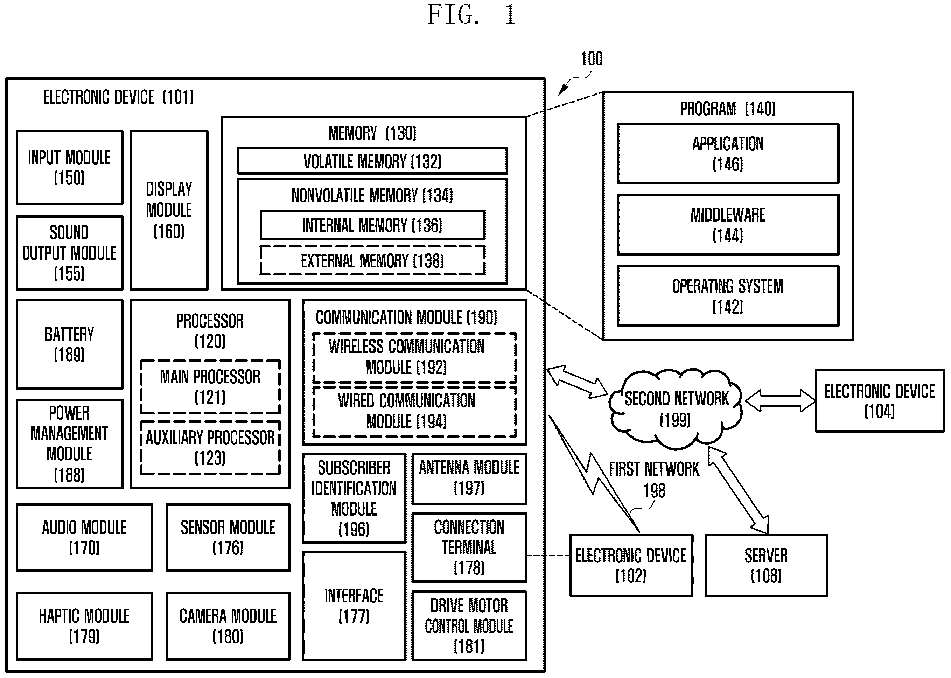

Fig. 1 is a block diagram illustrating an electronic device 101 in a network environment 100 according to various embodiments.

Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

According to an embodiment, a display module 160 may include a flexible display configured to be foldable or unfoldable.

According to an embodiment, the display module 160 may include a flexible display that is arranged to be slidable in a first direction (e.g., slidable in an x-axis direction) or in a second direction (e.g., slidable in a y-axis direction) to provide a screen (e.g., a display screen).

According to an embodiment, the display module 160 may also be referred to as a variable display (e.g., a stretchable display), an expandable display, or a slide-in/out display.

According to an embodiment, the display module 160 may also include a bar-type display or a plate-type display.

According to an embodiment, a processor 120, a memory 130, and electronic components of the electronic device 101 of FIG. 1 may be mounted on a printed circuit board (PCB) or a printed circuit board assembly (PBA).

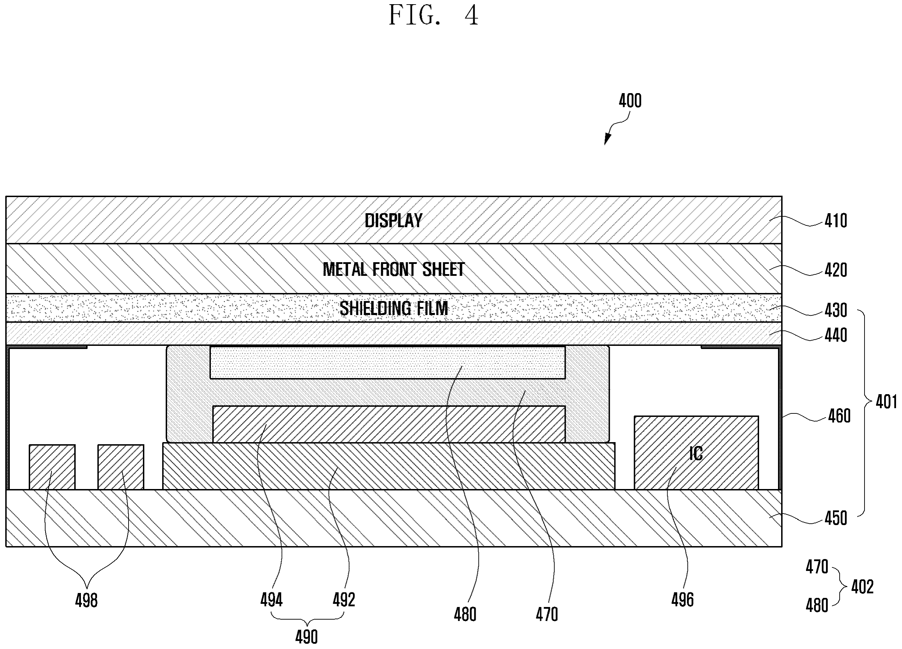

According to an embodiment, the electronic device 101 of FIG. 1 may include a heat dissipation structure (e.g., the composite heat dissipation structure 402 of FIG. 4) configured to dissipate heat generated from the processor 120, the memory 130, and the electronic components.

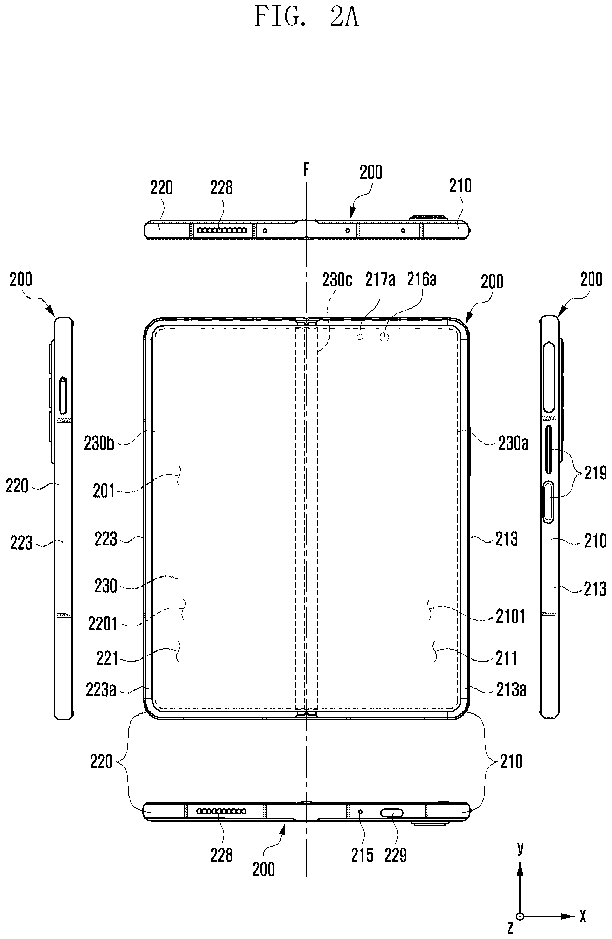

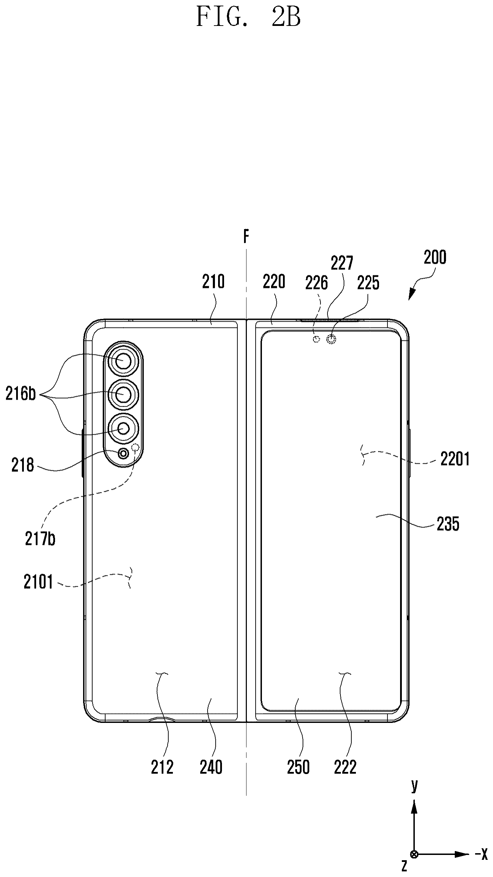

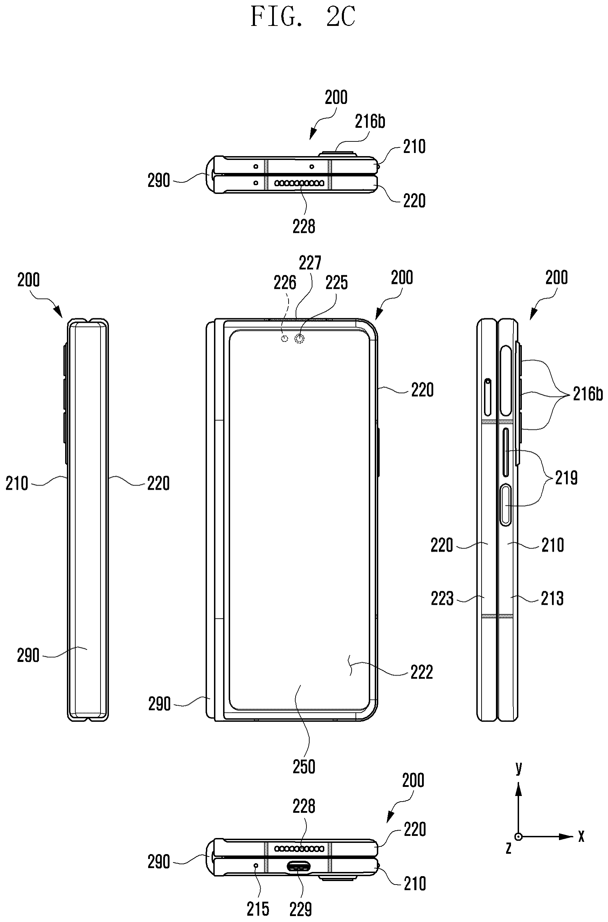

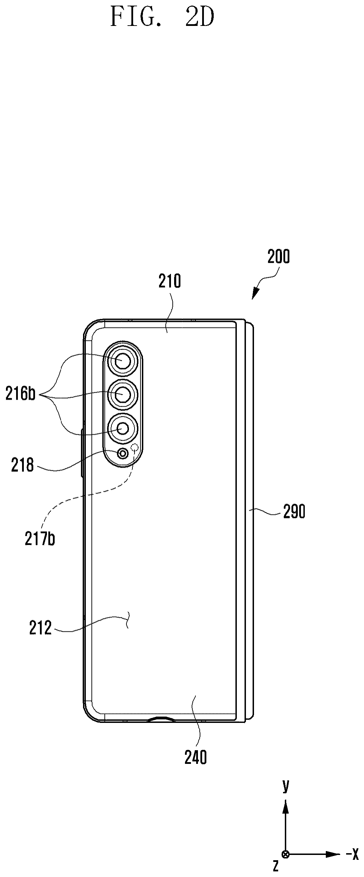

FIGS. 2A and 2B are views illustrating a first state (e.g., an unfolded state) of an electronic device according to an embodiment of the disclosure when viewed from the front and rear. FIGS. 2C and 2D are views illustrating a second state (e.g., a folded state) of the electronic device according to an embodiment of the disclosure when viewed from the front and rear.

Referring to FIGS. 2A to 2D, an electronic device 200 (e.g., the electronic device 101 of FIG. 1 or the electronic device 400 of FIG. 4) according to an embodiment of the disclosure may include a pair of housings 210 and 220 (e.g., a foldable housing structure) coupled to each other to be rotatable about a folding axis F via at least one hinge device (e.g., a hinge module or a hinge structure) so as to be foldable relative to each other, a first display 230 (e.g., a flexible display, a foldable display, or a main display) disposed across the pair of housings 210 and 220, and/or a second display 235 (e.g., a sub-display) disposed through the second housing 220.

According to an embodiment, at least a portion of at least one hinge device may be disposed through the first housing 210 and the second housing 220 so as to be invisible from the outside, and in the first state (e.g., the unfolded state), may be disposed so as to be invisible from the outside through a hinge housing 290 (e.g., a hinge cover) covering a foldable portion. Herein, a surface on which the first display 230 is disposed may be defined as a front surface of the electronic device 200. Herein, an opposite surface of the front surface may be defined as a rear surface of the electronic device 200. In addition, the surface surrounding the space between the front surface and the rear surface may be defined as the side surface of the electronic device 200.

According to an embodiment, the pair of housings 210 and 220 may include a first housing 210 and a second housing 220 that are foldable relative to each other via at least one hinge device.

According to an embodiment, the pair of housings 210 and 220 are not limited to the shape and assembly illustrated in FIGS. 2A to 2D, but may be implemented by other shapes or other combinations and/or assemblies of components.

According to an embodiment, the first housing 210 and the second housing 220 may be disposed on opposite sides of the folding axis F, may have shapes that are generally symmetrical to each other with respect to the folding axis F, and may be folded to match each other.

According to an embodiment, the first housing 210 and the second housing 220 may be folded asymmetrically with respect to the folding axis F.

According to an embodiment, the first housing 210 and the second housing 220 may form an angle or a distance therebetween, which may be variable depending on whether the electronic device 200 is in the first state (e.g., the unfolded state), the second state (e.g., the folded state), or the third state (e.g., the intermediate state). For example, the electronic device 200 may detect whether it is in the first state (e.g., the unfolded state), the second state (e.g., the folded state), or the third state (e.g., the intermediate state) by using a sensor module (e.g., the sensor module 176 of FIG. 1). The electronic device 200 may detect an angle formed between the first housing 210 and the second housing 220 by using a sensor module (e.g., the sensor module 176 of FIG. 1).

According to an embodiment, the first housing 210 may be connected to at least one hinge device when the electronic device 200 is in the first state (e.g., the unfolded state). The first housing 210 may include a first surface 211 oriented in a forward direction of the electronic device 200, a second surface 212 oriented in an opposite direction from the first surface 211, and/or a first side surface member 213 that surrounds at least a portion of a first space 2101 between the first surface 211 and the second surface 212.

According to an embodiment, the second housing 220 may be connected to at least one hinge device when the electronic device 200 is in the first state (e.g., the unfolded state). The second housing 220 may include a third surface 221 oriented in the forward direction of the electronic device 200, a fourth surface 222 oriented in an opposite direction from the third surface 221, and/or a second side surface member 223 that surrounds at least a portion of a second space 2201 between the third surface 221 and the fourth surface 222.

According to an embodiment, the first surface 211 may be oriented in substantially the same direction as the third surface 221 in the first state (e.g., the unfolded state) and may at least partially face the third surface 221 in the second state (e.g., the folded state).

According to an embodiment, the electronic device 200 may further include a recess 201 defined to accommodate the first display 230 through structural coupling between the first housing 210 and the second housing 220.

According to an embodiment, the recess 201 may have substantially the same size as the first display 230.

According to an embodiment, the first housing 210 may be coupled to the first side surface member 213 when the first display 230 is viewed from above. The first housing 210 may include a first protective frame 213a (e.g., a first decoration member) that covers an edge of the first display 230 so as to be invisible from the outside by overlapping the edge of the first display 230.

According to an embodiment, the first protective frame 213a may be integrated with the first side surface member 213.

According to an embodiment, the second housing 220 may be coupled to the second side surface member 223 when the first display 230 is viewed from above. The second housing 220 may include a second protective frame 223a that covers an edge of the first display 230 so as to be invisible from the outside by overlapping the edge of the first display 230.

According to an embodiment, the second protective frame 223a may be integrated with the second side surface member 223. In an embodiment, the first protective frame 213a and the second protective frame 223a may be omitted.

According to an embodiment, a hinge housing 290 (e.g., a hinge cover) may be disposed between the first housing 210 and the second housing 220. The hinge housing 290 may be disposed to cover at least a portion (e.g., at least one hinge module) of at least one hinge device.

According to an embodiment, the hinge housing 290 may be visually covered by a portion of the first housing 210 and the second housing 220 or may be exposed to the outside depending on whether the electronic device 200 is in the first state (e.g., the unfolded state), the second state (e.g., the folded state), or the third state (e.g., the intermediate state). For example, when the electronic device 200 is in the first state (e.g., the unfolded state), at least a portion of the hinge housing 290 may be covered by the first housing 210 and the second housing 220 so as to be substantially invisible from the outside.

According to an embodiment, when the electronic device 200 is in the second state (the folded state), at least a portion of the hinge housing 290 may be disposed between the first housing 210 and the second housing 220 so as to be visible from the outside.

According to an embodiment, in the third state (the intermediate state) in which the first housing 210 and the second housing 220 are folded with a certain angle, the hinge housing 290 may be disposed between the first housing 210 and the second housing 220 to be at least partially visible from the outside of the electronic device 200. For example, the area of the hinge housing 290 exposed to the outside may be smaller than that in the case where the electronic device is fully folded. According to an embodiment, the hinge housing 290 may include a curved surface.

According to an embodiment, when the electronic device 200 is in the first state (e.g., the unfolded state), the first housing 210 and the second housing 220 may form an angle of about 180 degrees, and a first area 230a, a second area 230b, and a folding area 230c of the first display 230 may be substantially coplanar. The first area 230a, the second area 230b, and the folding area 230c of the first display 230 may be oriented in substantially the same direction (e.g., the z-axis direction). As an example, when the electronic device 200 is in the first state (e.g., the unfolded state), the first housing 210 may be rotated relative to the second housing 220 by about 360 degrees so that the second surface 212 and the fourth surface 222 face each other (e.g., an out-folding type).

According to an embodiment, when the electronic device 200 is in the second state (the folded state), the first surface 211 of the first housing 210 and the third surface 221 of the second housing 220 may be disposed to face each other. In this case, the first area 230a and the second area 230b of the first display 230 may form a narrow angle (e.g., a range of 0 degrees to about 10 degrees) with each other via the folding area 230c and may be disposed to face each other. According to an embodiment, at least a portion of the folding area 230c may be transformed into a curved shape with a predetermined curvature.

According to an embodiment, when the electronic device 200 is in the third state (the intermediate state), the first housing 210 and the second housing 220 may be disposed to form a certain angle therebetween. In this case, the first area 230a and the second area 230b of the first display 230 may form an angle greater than that in the second state (e.g., the folded state) and smaller than that in the first state (e.g., the unfolded state), and the curvature of the folding area 230c may be smaller than that in the second state (e.g., the folded state) and greater than that in the first state (e.g., the unfolded state). In an embodiment, the first housing 210 and the second housing 220 may form an angle at a designated folding angle between the second state (e.g., the folded state) and the third state (e.g., the intermediate state) via at least one hinge device so as to stop at the angle (e.g., a free stop function). In an embodiment, the first housing 210 and the second housing 220 may be continuously operated while being pressed in the folding or unfolding direction with reference to a designated inflection angle via at least one hinge device.

According to an embodiment, the electronic device 200 may include at least one of the following components: one or more displays 230 and 235, input devices 215, sound output devices 227 and 228, sensor modules 217a, 217b, and 226, camera modules 216a, 216b, and 225, key input devices 219, indicators (not illustrated), or connector ports 229 which are disposed in or on the first housing 210 and/or the second housing 220. In an embodiment, the electronic device 200 may omit at least one of the components, or additionally include at least one other component.

According to an embodiment, the one or more displays 230 and 235 may include a first display 230 (e.g., a flexible display) disposed to be supported by the first surface 211 of the first housing 210 and the third surface 221 of the second housing 220 via the at least one hinge device, and a second display 235 disposed in the inner space of the second housing 220 to be at least partially visible from the outside through the fourth surface 222.

In an embodiment, the second display 235 may be disposed in the inner space of the first housing 210 to be visible from the outside through the second surface 212.

According to an embodiment, the first display 230 may be mainly used when the electronic device 200 is in the first state (e.g., the unfolded state). The second display 235 may also be used when the electronic device 200 is in the first state (e.g., the unfolded state).

According to an embodiment, the second display 235 may be mainly used when the electronic device 200 is in the second state (e.g., the folded state). The first display 230 may also be used when the electronic device 200 is in the second state (e.g., the folded state).

According to an embodiment, when the electronic device 200 is in the third state (e.g., the intermediate state), the electronic device 200 may be controlled such that the first display 230 and/or the second display 235 can be used based on the folding angle between the first housing 210 and the second housing 220.

According to an embodiment, the first display 230 may be placed in an accommodation space defined by the pair of housings 210 and 220. For example, the first display 200 may be disposed in the recess 201 defined by the pair of housings 210 and 220, and may be disposed to occupy substantially most of the front surface of the electronic device 200 in the first state (e.g., the unfolded state). According to an embodiment, the first display 230 may include a flexible display, at least a portion of which is transformable into a flat shape or a curved shape.

According to an embodiment, the first display 230 may include a first area 230a facing the first housing 210 and a second area 230b facing the second housing 220. According to an embodiment, the first display 230 may include a folding area 230c including a portion of the first area 230a and a portion of the second area 230b with reference to the folding axis F.

According to an embodiment, at least a portion of the folding area 230c may include an area corresponding to the at least one hinge device.

According to an embodiment, the area division of the first display 230 is merely an exemplary physical division based on the pair of housings 210 and 220 and the at least one hinge device, and in practice, the first display 230 may display a single seamless entire screen via the pair of housings 210 and 220 and the at least one hinge device.

According to an embodiment, the first area 230a and the second area 230b may have an overall symmetrical shape or a partially asymmetrical shape with respect to the folding area 230c.

According to an embodiment, the electronic device 200 may include a first rear surface cover 240 disposed on the second surface 212 of the first housing 210 and a second rear surface cover 250 disposed on the fourth surface 222 of the second housing 220. In an embodiment, at least a portion of the first rear surface cover 240 may be integrated with the first side surface member 213. In an embodiment, at least a portion of the second rear surface cover 250 may be integrated with the second side surface member 223.

According to an embodiment, at least one of the first rear surface cover 240 and the second rear surface cover 250 may be made of a substantially transparent plate (e.g., a glass plate including various coating layers, or a polymer plate) or an opaque plate. According to an embodiment, the first rear surface cover 240 may be made of, for example, coated or colored glass, ceramic, polymer, metal (e.g., aluminum, stainless steel (STS), or magnesium), or an opaque plate such as a combination of two or more of these materials.

According to an embodiment, the second rear surface cover 250 may be made of a substantially transparent plate of, for example, glass or polymer. Accordingly, the second display 235 may be disposed in the inner space of the second housing 220 to be visible from the outside through the second rear surface cover 250.

According to an embodiment, the input devices 215 may include a microphone. In an embodiment, the input devices 215 may include a plurality of microphones disposed to detect the direction of sound.

According to an embodiment, the sound output devices 227 and 228 may include speakers. According to an embodiment, the sound output devices 227 and 228 may include a call receiver 227 disposed through the fourth surface 222 of the second housing 220, and an external speaker 228 disposed through at least a portion of the second side surface member 223 of the second housing 220.

In an embodiment, the input device 215, the sound output devices 227 and 228, and the connector port 229 may be disposed in spaces of the first housing 210 and/or the second housing 220. The input device 215, the sound output devices 227 and 228, and the connector port 229 may be exposed to an external environment through at least one hole formed in the first housing 210 and/or the second housing 220. In an embodiment, the holes provided in the first housing 210 and/or the second housing 220 may be commonly used for the input device 215 and the sound output devices 227 and 228. In an embodiment, the sound output devices 227 and 228 may include a speaker that operates without holes provided in the first housing 210 and/or the second housing 220 (e.g., a piezo speaker).

According to an embodiment, the camera modules 216a, 216b, and 225 may include a first camera module 216a disposed on the first surface 211 of the first housing 210, a second camera module 216b disposed on the second surface 212 of the first housing 210, and/or a third camera module 225 disposed on the fourth surface 222 of the second housing 220.

According to an embodiment, the electronic device 200 may include a flash 218 located near the second camera module 216b. According to an embodiment, the flash 218 may include, for example, a light-emitting diode or a xenon lamp.

According to an embodiment, the camera modules 216a, 216b, and 225 may include one or more lenses, an image sensor, and/or an image signal processor. In an embodiment, at least one of the camera modules 216a, 216b, and 225 may include two or more lenses (e.g., wide-angle and telephoto lenses) and image sensors, and the camera modules may be disposed together on one surface of the first housing 210 and/or the second housing 220.

According to an embodiment, the sensor modules 217a, 217b, and 226 (e.g., the sensor module 176 in FIG. 1) may generate an electrical signal or a data value corresponding to the internal operating state or the external environmental state of the electronic device 200.

According to an embodiment, the sensor modules 217a, 217b, and 226 (e.g., the sensor module 176 of FIG. 1) may include a first sensor module 217a disposed on the first surface 211 of the first housing 210, a second sensor module 217b disposed on the second surface 212 of the first housing 210, and/or a third sensor module 226 disposed on the fourth surface 222 of the second housing 220.

In an embodiment, the sensor modules 217a, 217b, and 226 (e.g., the sensor module 176 of FIG. 1) may include at least one of a gesture sensor, a gyro sensor, a grip sensor, a color sensor, an infrared (IR) sensor, an illuminance sensor, an ultrasonic sensor, a proximity sensor, a biometric sensor (e.g., an iris recognition sensor), a distance detection sensor (e.g., a time of flight (TOF) sensor or a light detection and ranging (LiDAR) sensor), a barometric pressure sensor, a magnetic sensor (e.g., a six-axis sensor or a geomagnetic sensor), an acceleration sensor, a temperature sensor, a humidity sensor, and/or a fingerprint recognition sensor.

According to an embodiment, a processor (e.g., the processor 120 of FIG. 1) of the electronic device 200 may operate the sensor modules 217a, 217b, and 226 (e.g., the sensor module 176 of FIG. 1) to detect illuminance and/or IR intensity around the electronic device 200. The processor 120 may acquire information regarding the illuminance and the IR intensity around the electronic device 200.

According to an embodiment, the electronic device 200 may include at least one of a gesture sensor, a gyro sensor, a grip sensor, a color sensor, an infrared (IR) sensor, an illuminance sensor, an ultrasonic sensor, a proximity sensor, a biometric sensor (e.g., an iris recognition sensor), a distance detection sensor (e.g., a time of flight (TOF) sensor or a light detection and ranging (LiDAR) sensor), a barometric pressure sensor, a magnetic sensor (e.g., a six-axis sensor or a geomagnetic sensor), an acceleration sensor, a temperature sensor, a humidity sensor, and/or a fingerprint recognition sensor, which are not illustrated.

In an embodiment, the fingerprint recognition sensor may be disposed through at least one of the first side surface member 213 of the first housing 210 and/or the second side surface member 223 of the second housing 220.

According to an embodiment, the key input devices 219 may be disposed to be visually exposed outside through the first side surface member 213 of the first housing 210. In an embodiment, the key input devices 219 may be disposed to be visually exposed outside through the second side surface member 223 of the second housing 220. In an embodiment, the electronic device 200 may not include some or all of the above-mentioned key input devices 219, and a key input device 219, which is not included, may be implemented in another form, such as a soft key, on at least one display 230 or 235. As an embodiment, the key input devices 219 may be implemented by using a pressure sensor included in the at least one display 230 or 235.

According to an embodiment, the connector ports 229 may include a connector (e.g., a USB connector or an interface connector port module (IF module)) configured to transmit/receive power and/or data to/from an external electronic device. In an embodiment, the connector ports 229 may further include a separate connector port (e.g., an ear jack hole) for performing a function for transmitting/receiving an audio signal to and from the external electronic device or an audio signal transmitting/receiving function.

According to an embodiment, at least one camera module 216a or 225 among the camera modules 216a, 216b, and 225, at least one sensor module 217a or 226 among the sensor modules 217a, 217b, and 226, and/or an indicator may be disposed to be visually exposed through the at least one display 230 or 235. For example, at least one camera module 216a or 225, at least one sensor module 217a or 226, and/or an indicator may be disposed under a display area of at least one display 230 or 235 in an inner space of at least one housing 210 or 220. At least one camera module 216a or 225, at least one sensor module 217a or 226, and/or the indicator may be disposed to come into contact with an external environment through an opening or a transparent area perforated through or formed in a cover member (e.g., a window layer (not illustrated) of the first display 230 and/or the second rear surface cover 250).

According to an embodiment, an area in which the at least one display 230 or 235 and the at least one camera module 216a or 225 face each other may be provided as a transmissive area with a predetermined transmittance as a portion of a content display area.

According to an embodiment, the transmissive area may have a transmittance ranging from about 5% to about 20%. The transmissive area may include an area overlapping the effective area (e.g., a view angle area) of the at least one camera module 216a or 225 through which light imaged by an image sensor to generate an image passes. For example, the transmissive area of the display 230 or 235 may include an area having a lower pixel density than the periphery. For example, the transmissive area may replace an opening. For example, the at least one camera module 216a or 225 may include an under-display camera (UDC) or an under-panel camera (UPC). As an embodiment, some camera modules or sensor modules 217a and 226 may be disposed to perform the functions thereof without being visually exposed through a display. For example, the areas facing the camera modules 216a and 225 and/or the sensor modules 217a and 226 disposed under the displays 230 and 235 (e.g., a display panel) may have an under-display camera (UDC) structure, and may not require a perforated opening.

According to an embodiment, a processor (e.g., the processor 120 of FIG. 1), a memory (e.g., the memory 130 of FIG. 1), and electronic components of the electronic device 200 of FIGS. 2A and 2B may be mounted on a printed circuit board (PCB) or a printed circuit board assembly (PBA).

According to an embodiment, the electronic device 200 of FIGS. 2A and 2B may include a heat dissipation structure (e.g., the composite heat dissipation structure 402 of FIG. 4) configured to dissipate heat generated from the processor 120, the memory 130, and the electronic components.

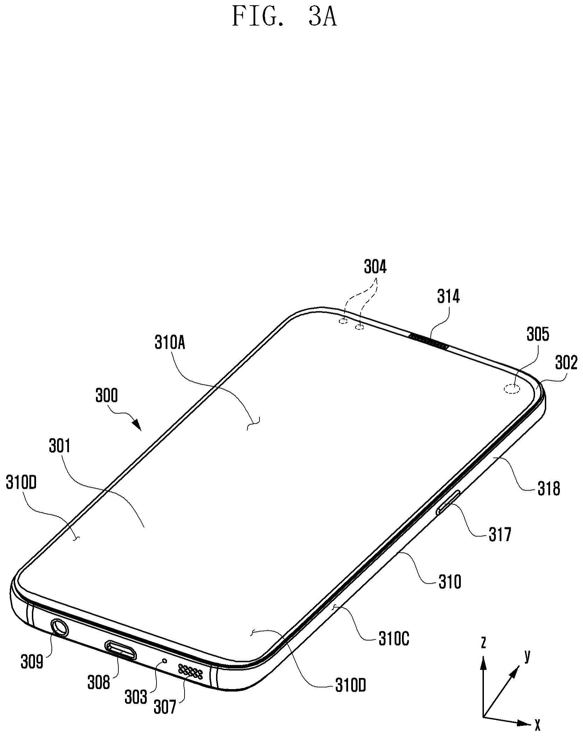

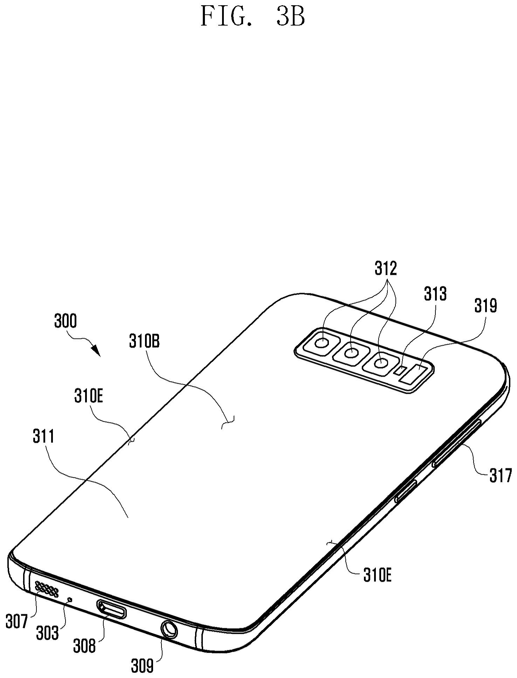

FIG. 3A is a perspective view of a first surface (e.g., a front surface) of an electronic device according to an embodiment of the disclosure. FIG. 3B is a perspective view of a second surface (e.g., a rear surface) of the electronic device according to an embodiment of the disclosure.

Referring to FIGS. 3A and 3B, an electronic device 300 (e.g., the electronic device 101 of FIG. 1 or the electronic device 400 of FIG. 4) according to an embodiment of the disclosure may include a first surface (or a front surface) 310A, a second surface (or a rear surface) 310B, and a housing 310. The electronic device 300 (e.g., the electronic device 101 of FIG. 1 or the electronic device 400 of FIG. 4) according to an embodiment of the disclosure may include a display 301 (e.g., the display 410 of FIG. 4).

According to an embodiment, the display 301 may be supported by the housing 310. For example, the display 301 may include a liquid crystal display (LCD) display, an organic light-emitting diode (OLED) display, or a micro light-emitting diode (micro LED) display.

According to an embodiment, the housing 310 may include a side surface 310C surrounding a space between the first surface 310A and the second surface 310B. According to an embodiment, the housing 310 may also refer to a structure that at least partially forms the first surface 310A, the second surface 310B, and the side surface 310C.

According to an embodiment, at least a portion of the first surface 310A may be defined by a substantially transparent front surface plate 302 (e.g., a glass plate or a polymer plate including various coating layers).

According to an embodiment, the second surface 310B may be defined by a substantially opaque rear surface plate 311. The rear surface plate 311 may be made of, for example, coated or colored glass, ceramic, polymer, metal (e.g., aluminum, stainless steel (STS), or magnesium), or a combination of two or more of these materials. However, the disclosure is not limited thereto, and the rear plate 311 may be formed of transparent glass.

According to an embodiment, the side surface 310C may be defined by a side surface bezel structure 318 (or a "side surface member") coupled to the front surface plate 302 and the rear surface plate 311 and including metal and/or polymer. According to an embodiment, the rear plate 311 and the side bezel structure 318 may be integrally formed, and may include the same material (e.g., a metal material such as aluminum).

According to an embodiment, the front surface plate 302 may include two first areas 310D that are curved from the first surface 310A toward the rear surface plate 311 and extend seamlessly. The two first areas 310D may be disposed at opposite long edge ends of the front surface plate 302.

According to an embodiment, the rear surface plate 311 may include two second areas 310E that are curved from the second surface 310B toward the front surface plate 302 and extend seamlessly.

According to an embodiment, the front surface plate 302 (or the rear surface plate 311) may include only one of the first areas 310D (or the second areas 310E). According to an embodiment, some of the first areas 310D or the second areas 310E may not be included.

In some embodiments, when viewed from a side of the electronic device 300, the side surface bezel structure 318 may have a first thickness (or width) at a side where the first areas 310D or the second areas 310E as described above are not included. In some embodiments, when viewed from a side of the electronic device 300, the side surface bezel structure 318 may have a second thickness (or width) smaller than the first thickness at a side surfaces where the first areas 310D or the second areas 310E are included.

According to an embodiment, the electronic device 300 may include at least one of a display 301, an sound input device 303 (e.g., the input module 150 of FIG. 1, a microphone), sound output devices 307 and 314 (e.g., the sound output module 155 of FIG. 1 or a speaker) (e.g., an audio module), sensor modules 304 and 319 (e.g., the sensor module 176 of FIG. 1), camera modules 305 and 312 (e.g., the camera module 180 of FIG. 1), a flash 313, a key input device 317, an indicator (not illustrated), and connectors 308 and 309. According to an embodiment, the electronic device 300 may omit at least one of the components (e.g., the key input device 317) or additionally include other components.

According to an embodiment, the display 301 may be visually exposed through an upper end portion of the front surface plate 302.

According to an embodiment, at least a portion of the display 301 may be visible through the front surface plate 302 that forms the first surface 310A and the first areas 310D of the side surface 310C.

According to an embodiment, at least a portion of the sensor modules 304 and 319 and/or at least a portion of the key input device 317 may be disposed in the first areas 310D and/or the second areas 310E.

According to an embodiment, at least one of the first sensor module 304, the camera modules 305 and 312 (e.g., image sensors), the sound output device 314 (e.g., an audio module), and a fingerprint sensor may be provided on the rear surface of a screen display area of the display 301.

According to an embodiment, at least a portion of the sensor modules 304 and 319 and/or at least a portion of the key input device 317 may be disposed in the first areas 310D and/or the second areas 310E.

According to an embodiment, the sound input device 303 may include a microphone. According to an embodiment, the sound input device 303 may include a plurality of microphones arranged to detect the direction of sound.

According to an embodiment, the sound output devices 307 and 314 may include a sound output device 307 operating as an external speaker and a sound output device 314 operating as a call receiver.

In some embodiments, the sound input device 303 (e.g., a microphone), the sound output devices 307 and 314, and the connectors 308 and 309 may be disposed in an inner space of the electronic device 300. The sound input device 303 (e.g., a microphone), the sound output devices 307 and 314, and the connectors 308 and 309 may be exposed to an external environment through at least one hole formed in the housing 310. In some embodiments, the holes provided in the housing 310 may be commonly used for the sound input device 303 (e.g., a microphone) and the sound output devices 307 and 314. In some embodiments, the sound output devices 307 and 314 may include a speaker that operates without a hole formed in the housing 310 (e.g., a piezo speaker).

According to an embodiment, the sensor modules 304 and 319 (e.g., the sensor module 176 in FIG. 1) may generate an electrical signal or a data value corresponding to the internal operating state or the external environmental state of the electronic device 300. The sensor modules 304 and 319 may include a first sensor module 304 (e.g., a proximity sensor) arranged on the first surface 310A of the housing 310, a second sensor module 319 (e.g., an HRM sensor) arranged on the second surface 310B of the housing 310, and/or a third sensor module (not illustrated) (e.g., a fingerprint sensor). For example, the fingerprint sensor may be arranged on the first surface 310A (e.g., the display 301) and/or the second surface 310B of the housing 310.

The electronic device 300 may further include at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor (not illustrated).

According to an embodiment, the camera modules 305 and 312 may include a first camera module 305 arranged on the first surface 310A of the electronic device 300, and a second camera module 312 arranged on the second surface 310B of the electronic device 200. A flash 313 may be disposed around the camera modules 305 and 312. The camera modules 305 and 312 may include one or more lenses, an image sensor, and/or an image signal processor. The flash 313 may include, for example, a light-emitting diode or a xenon lamp.

According to an embodiment, the first camera module 305 may be arranged under the display panel of the display 301 in a manner of an under-display camera (UDC). According to an embodiment, two or more lenses (a wide-angle lens and a telephoto lens) and image sensors may be arranged on one surface of the electronic device 300. According to an embodiment, a plurality of first camera modules 305 may be disposed on the first surface of the electronic device 300 (e.g., the surface on which a screen is to be displayed) in an under-display camera (UDC) manner.

According to an embodiment, the key input devices 317 may be disposed on the side surface 310C of the housing 310. According to an embodiment, the electronic device 300 may not include some or all of the above-mentioned key input devices 317, and key input devices 317, which are not included, may be implemented in another form, such as soft keys, on the display 301. According to an embodiment, the key input devices 317 may be implemented using pressure sensors included in the display 301.

According to an embodiment, the connector holes 308 and 309 may include a first connector hole 308 capable of accommodating a connector (e.g., a USB connector) configured to transmit/receive power and/or data to/from an external electronic device, and/or a second connector hole 309 (or an earphone jack) capable of accommodating a connector configured to transmit/receive audio signals to/from an external electronic device. The first connector hole 308 may include a universal serial bus (USB) A type, a USB B type, or a USB C type port. When the first connector hole 308 supports the USB C type, the electronic device 300 (e.g., the electronic device 101 of FIG. 1, the electronic device 200 of FIG. 2A, or the electronic device 400 of FIG. 4) may support USB power delivery (PD) charging.

According to an embodiment, a first camera module 305 among the camera modules 305 and 312 and/or a first sensor module 304 among the sensor modules 304 and 319 may be disposed to be visually exposed through the display 301.

According to an embodiment, when the first camera module 305 is disposed in an under display camera (UDC) manner, the first camera module 305 may not be visually exposed to the outside.

According to an embodiment, the first camera module 305 may be disposed to overlap the display area, and a screen may be displayed even in a display area corresponding to the first camera module 305. The first sensor module 304 may be disposed to execute their functions in the internal space of the electronic device 300 without being visually exposed through the front surface plate 302.

According to an embodiment, a processor (e.g., the processor 120 of FIG. 1), a memory (e.g., the memory 130 of FIG. 1), and electronic components of the electronic device 300 of FIGS. 3A and 3B may be mounted on a printed circuit board (PCB) or a printed circuit board assembly (PBA).

According to an embodiment, the electronic device 300 of FIGS. 3A and 3B may include a heat dissipation structure (e.g., the composite heat dissipation structure 402 of FIG. 4) configured to dissipate heat generated from the processor 120, the memory 130, and the electronic components.

FIG. 4 is a view illustrating a printed circuit board assembly including a heat dissipation structure and an electronic device including the printed circuit board assembly, according to an embodiment of the disclosure.

The electronic device 400 of FIG. 4 may include at least a portion of the electronic device 101 of FIG. 1. The electronic device 400 of FIG. 4 may include at least a portion of the electronic device 200 of FIGS. 2A and 2B. Referring to FIG. 4, the electronic device 400 according to an embodiment of the disclosure may include at least a portion of the electronic device 300 of FIGS. 3A and 3B.

Referring to FIG. 4, the electronic device 400 according to an embodiment of the disclosure may include a display 410 (e.g., the display module 160 of FIG. 1, the first display 230 (a flexible display) of FIG. 2A, or the display 301 of FIG. 3A), a metal front sheet 420 supporting the display 410, and a printed circuit board assembly 401. For example, the metal front sheet 420 may include a heat spreading member (e.g., a graphite sheet, a metal sheet (Cu), a heat pipe, or a vapor chamber).

According to an embodiment, the printed circuit board assembly 401 may include a shielding layer 430 (e.g., a shielding film, a shielding plate, or a shielding sheet), an adhesive material layer 440 (e.g., an adhesive film, an adhesive plate, or an adhesive sheet), a printed circuit board 450 (e.g., a PCB or a PBA), a shield can 460, a composite heat dissipation structure 402, and electronic components such as heat-generating components 490, an integrated circuit (IC) 496, and other electronic components 498 (e.g., peripheral circuit components or passive elements).

The shield can 460 may be disposed to shield the electronic components. For example, the shield can 460 may be a metal/conductive structure disposed to at least partially surround the electronic components. For example, the shield can 460 may have side surfaces perpendicular (or substantially perpendicular) to the surface of printed circuit board 450 on which the electronic components are mounted such that the side surfaces surround the area of the printed circuit board 450 on which the electronic components are mounted. The shield can 460 may have an upper surface parallel (or substantially parallel) to the surface of printed circuit board 450 on which the electronic components are mounted. The upper surface may include an opening. The opening may be covered by the shielding layer 430 and/or adhesive material layer 440 when the printed circuit board assembly 401 is assembled.

According to an embodiment, the electronic components (e.g. heat-generating components 490, the integrated circuit 496, and the other electronic components 498) may be mounted on the printed circuit board 450.

According to an embodiment, the heat-generating components 490 may include a memory 494 (e.g., the memory 130 of FIG. 1 or a DRAM) and a processor 492 (e.g., the processor 120 of FIG. 1). For example, the memory 494 and the processor 492 may be stacked on the printed circuit board 450.

For example, the processor 492 may be mounted on the printed circuit board 450, and the memory 494 may be stacked on the processor 492. However, the disclosure is not limited thereto, and the memory 494 may be disposed on the printed circuit board 450, and the processor 492 may be stacked on the memory 494.

For example, the integrated circuit 496 and the other electronic components 498 may be disposed around the memory 494 and the processor 492.

For example, the memory 494 may include at least one of a high-bandwidth memory (HBM), a dynamic random access memory (DRAM), a static random access memory (SRAM), a phase-change random access memory (PRAM), a magnetic random access memory (MRAM), a resistive random access memory (RRAM), a flash memory, and an electrically erasable programmable read-only memory (EEPROM).

For example, the processor 492 may include at least one of a main processor (e.g., the main processor 121 of FIG. 1, a central processing unit (CPU) or an application processor), a sub-processor (e.g., the sub-processor 123 of FIG. 1, a graphics processing unit (GPU), a neural processing unit (NPU), an image signal processor, a sensor hub processor, or a communication processor), and/or a graphics processing unit (GPU).

According to an embodiment, the composite heat dissipation structure 402 may be disposed to at least partially cover the heat generating components 490 (e.g. to at least partially cover the memory 494 and the processor 492) so as to dissipate heat generated from the heat generating components 490 (e.g. memory 494 and the processor 492).

According to an embodiment, the shielding layer 430 (e.g. shielding film) may be disposed to cover the composite heat dissipation structure 402 and the shield can 460.

For example, the shielding layer 430 (e.g. shielding film) may include a material having high electrical conductivity and high thermal conductivity (e.g., a metal) or an alloy (e.g., CuSi). For example, the shielding layer 430 (e.g. shielding film)may include a material having high thermal conductivity, such as stainless steel, copper (Cu), nickel (Ni), silver (Ag), gold (Au), silicon (Si), or aluminum (Al). For example, the shielding layer 430 (e.g. shielding film)may include a composite material including a thermally conductive filler or a polymer.

For example, to attach the shielding layer 430 (e.g. shielding film)onto the composite heat dissipation structure 402 and the shield can 460, an adhesive material layer 440 may be disposed between upper portions of the composite heat dissipation structure 402 and the shield can 460 and the shielding layer 430 (e.g. shielding film). The upper portions may include portions with surfaces facing (or substantially facing) the same direction as the surface of the printed circuit board 450 on which the electronic components are mounted. The upper portions may include portions with surfaces not facing (or not substantially facing) the surface of the printed circuit board 450 on which the electronic components are mounted. For example, the adhesive material layer 440 may include a porous conductive adhesive material.

According to an embodiment, the composite heat dissipation structure 402 may include a first heat dissipation structure 470 (e.g., an (electrically) insulating heat dissipation structure or a first TIM) and a second heat dissipation structure 480 (e.g., a (electrically) conductive heat dissipation structure or a second TIM).

For example, the first heat dissipation structure 470 (e.g., the insulating heat dissipation structure) may be disposed to cover at least a portion of the upper surfaces of the heat-generating components 490. The first heat dissipation structure 470 (e.g., the insulating heat dissipation structure) may be disposed to cover upper surfaces of the memory 494 and the processor 492. The upper surfaces may include surfaces facing (or substantially facing) the same direction as the surface of the printed circuit board 450 on which the electronic components are mounted. The upper surfaces may include surfaces not facing (or not substantially facing) the surface of the printed circuit board 450 on which the electronic components are mounted.

For example, the second heat dissipation structure 480 (e.g., the conductive heat dissipation structure) may be disposed to cover at least a portion of an upper surface of the first heat dissipation structure 470 (e.g., the insulating heat dissipation structure).

The first heat dissipation structure 470 may be disposed to at least partially surround the second heat dissipation structure 480. For example, a groove having a predetermined depth may be formed on the upper surface of the first heat dissipation structure 470 (e.g., the insulating heat dissipation structure), and the second heat dissipation structure 480 (e.g., the conductive heat dissipation structure) may be disposed in the groove formed on the upper surface of the first heat dissipation structure 470 (e.g., the insulating heat dissipation structure).

For example, the upper surface of the first heat dissipation structure 470 (e.g., the insulating heat dissipation structure) and the upper surface of the second heat dissipation structure 480 (e.g., the conductive heat dissipation structure) may be disposed to be in contact with a lower surface of the adhesive material layer 440. The lower surface may be a surface facing (or substantially facing) the surface of the printed circuit board 450 on which the electronic components are mounted.

According to an embodiment, the first heat dissipation structure 470 (e.g., the insulating heat dissipation structure) and the second heat dissipation structure 480 (e.g., the conductive heat dissipation structure) of the composite heat dissipation structure 402 may have different compressibilities. For example, the first heat dissipation structure 470 may have a higher compressibility than the second heat dissipation structure 480.

According to an embodiment, the first heat dissipation structure 470 (e.g., the insulating heat dissipation structure) may include a heat spreading (thermal conduction) member, a thermal grease, a heat dissipation paste, or a heat spreading (thermal conduction) paste.

For example, the first heat dissipation structure 470 (e.g., the insulating heat dissipation structure) may include an adhesive material and an (electrically) insulating TIM. The first heat dissipation structure 470 (e.g., the insulating heat dissipation structure) may include a ceramic-based non-conductive filler (e.g., alumina, aluminum nitride, or boron nitride).

For example, the first heat dissipation structure 470 (e.g., an insulating heat dissipation structure) may have a lower thermal conductivity than the second heat dissipation structure 480 (e.g., the conductive heat dissipation structure).

For example, the first heat dissipation structure 470 (e.g., an insulating heat dissipation structure) may have a thermal conductivity of 2 to 4 W/mK.

For example, the first heat dissipation structure 470 (e.g., the insulating heat dissipation structure) may have a compressibility of 15% to 30% under a pressure condition of 10 to 20 psi.

For example, the first heat dissipation structure 470 (e.g., the insulating heat dissipation structure) may have a thickness of 0.1 to 0.3 mm.

According to an embodiment, the second heat dissipation structure 480 (e.g., the conductive heat dissipation structure) may include a heat spreading (thermal conduction) member, a thermal grease, a heat dissipation paste, or a heat spreading (thermal conduction) paste.

For example, the second heat dissipation structure 480 (e.g., the conductive heat dissipation structure) may include an adhesive material and a (electrically) conductive TIM. The second heat dissipation structure 480 (e.g., the conductive heat dissipation structure) may include a carbon-based conductive filler (e.g., carbon nanotube, carbon fiber, graphene, or graphite).

For example, the second heat dissipation structure 480 (e.g., the conductive heat dissipation structure) may have a thermal conductivity of 20 to 40 W/mK.

For example, the second heat dissipation structure 480 (e.g., the conductive heat dissipation structure) may have a compressibility of 0.1% to 15% under a pressure condition of 10 to 20 psi.

For example, the second heat dissipation structure 480 (e.g., the conductive heat dissipation structure) may have a thickness of 0.1 to 0.3 mm.

According to an embodiment, as the power generated from the processor (e.g., an application processor) continuously increases, a TIM having a higher thermal conductivity needs to be applied to effectively remove the high heat generated from the processor (e.g., an application processor). Since higher electrical conductivity also means higher thermal conductivity, a filler having high electrical conductivity may be used as the TIM.

According to an embodiment, in the disclosure, in order to achieve high thermal conductivity, a ceramic-based non-conductive filler (e.g., alumina, aluminum nitride, or boron nitride) may be applied as a TIM of the first heat dissipation structure 470 (e.g., the insulating heat dissipation structure).

According to an embodiment, in the disclosure, in order to achieve high thermal conductivity, a carbon-based conductive filler (e.g., carbon fiber, graphite, carbon nanotube, or graphene) may be applied as a TIM of the second heat dissipation structure 480 (e.g., the conductive heat dissipation structure).

According to an embodiment, in the disclosure, in order to achieve high thermal conductivity, a metal-based conductive filler (e.g., aluminum, copper, or silver) may be applied as a TIM of the second heat dissipation structure 480 (e.g., the conductive heat dissipation structure).

According to an embodiment, in the disclosure, in order to achieve higher thermal conductivity, the first heat dissipation structure 470 (e.g., the insulating heat dissipation structure) and the second heat dissipation structure 480 (e.g., the conductive heat dissipation structure) may be vertically aligned and applied. The vertical direction may be considered to be the direction perpendicular to the surface of the surface of the printed circuit board 450 on which the electronic components are mounted.

For example, in the disclosure, in order to achieve higher thermal conductivity, fillers contained in the first heat dissipation structure 470 (e.g., the insulating heat dissipation structure) may be vertically aligned and applied.

For example, in the disclosure, in order to achieve higher thermal conductivity, fillers contained in the second heat dissipation structure 480 (e.g., the conductive heat dissipation structure) may be vertically aligned and applied.

**[Table 1]**

| Type of Filler | | Electrical Conductivity (S/cm) | Thermal Conductivity (W/mK) |
|---|---|---|---|
| Carbon-based (conductive) | Carbon fiber (CF) | 10⁴ | 1000 |
| | Graphite (GR) | 10⁵ | 2000 |
| | Carbon nanotube (CNT) | 10⁵ | 3000 |
| | Graphene | 10⁶ | 5000 |
| Metal-based (conductive) | Aluminum (Al) | 3.7 x 10⁵ | 234 |
| | Copper (Cu) Silver (Ag) | 5.9 x 10⁵ 6.3 x 10⁵ | 386 417 |
| Ceramic-based (non-conductive) | Alumina (Al₂O₃) | - | 30 |

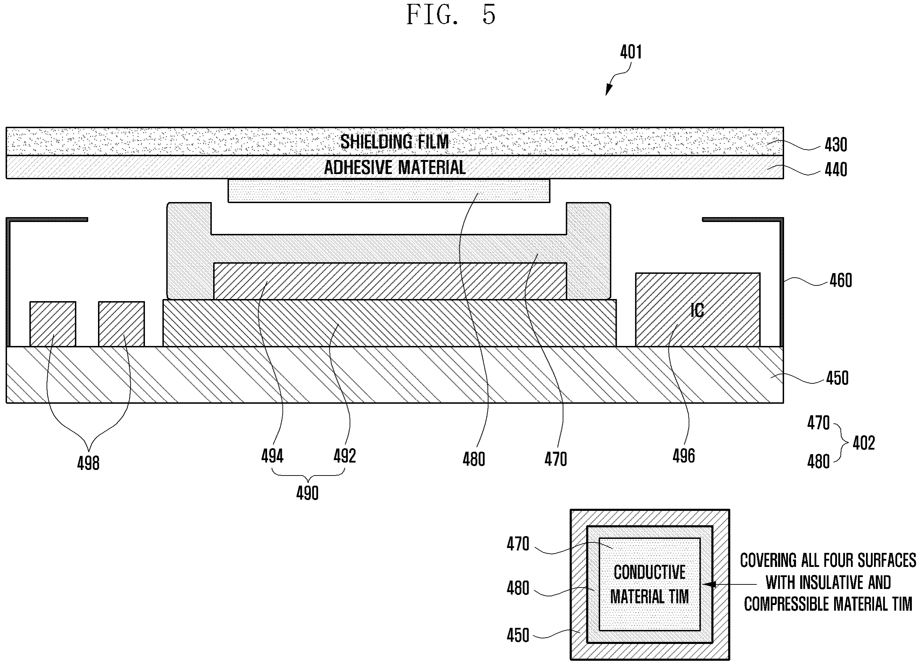

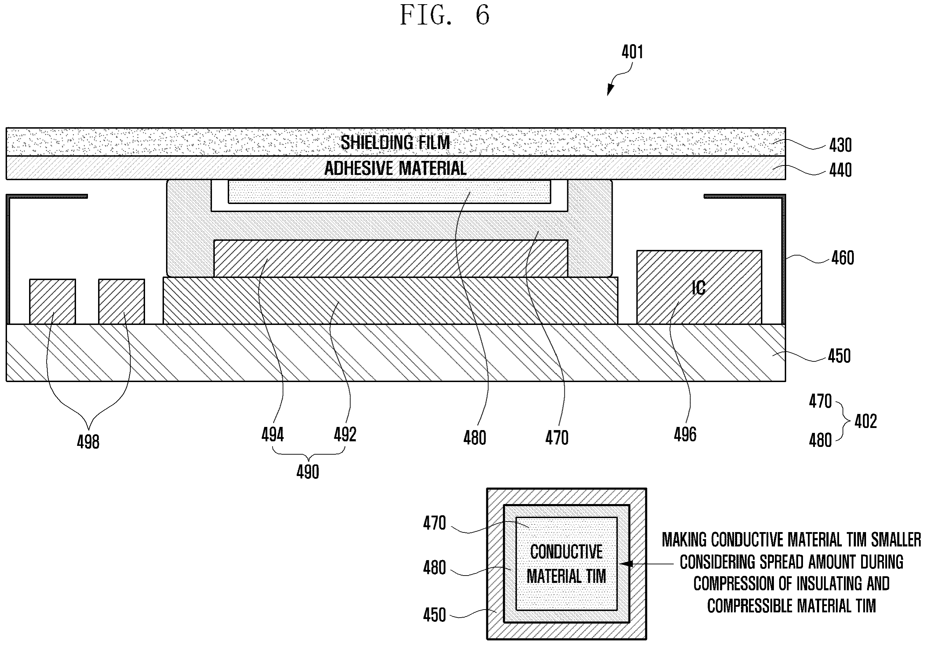

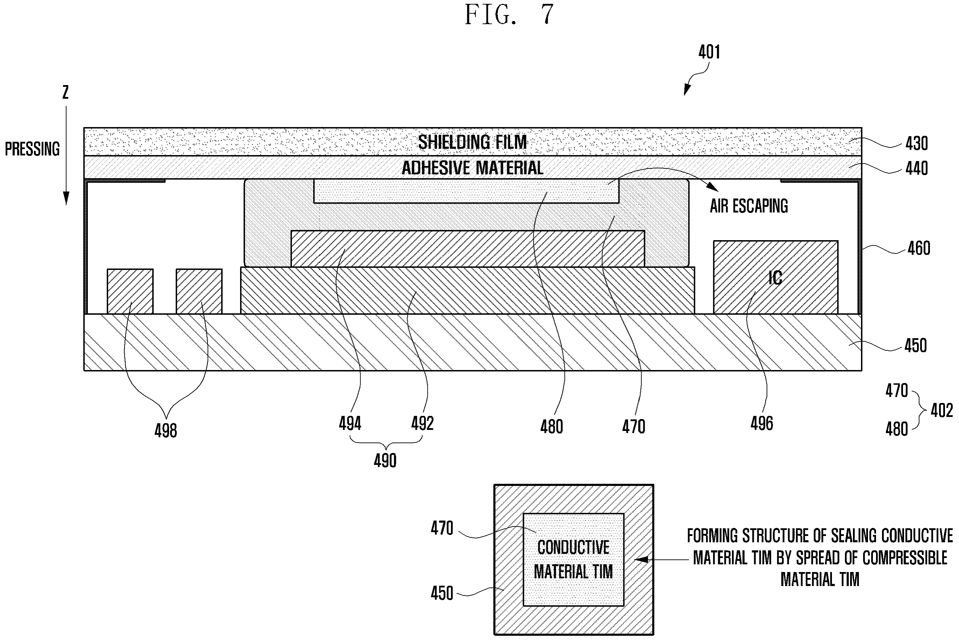

FIGS. 5 to 7 are views illustrating a method of forming the heat dissipation structure of the printed circuit board assembly illustrated in FIG. 4.

Referring to FIGS. 4 and 5 to 7, the first heat dissipation structure 470 (e.g., the insulating heat dissipation structure) may be disposed to cover upper surfaces of at least some of the heat-generating components 490. For example, the first heat dissipation structure 470 (e.g., the insulating heat dissipation structure) may be disposed to cover upper surfaces of both the memory 494 and the processor 492.

For example, during the manufacturing process, considering the amount of spreading of the TIM of the first heat dissipation structure 470 (e.g., the insulating heat dissipation structure) caused by pressure in the vertical direction (e.g., the z-axis direction or the direction perpendicular to the surface of the surface of the printed circuit board 450 on which the electronic components are mounted), the first heat dissipation structure 470 (e.g., the insulating heat dissipation structure) may be disposed to have a relatively smaller area (e.g., a relatively smaller planar area) than that of the second heat dissipation structure 480 (e.g., the conductive heat dissipation structure). A groove having a predetermined depth may be formed in an upper surface of the first heat dissipation structure 470 (e.g., the insulating heat dissipation structure). The second heat dissipation structure 480 (e.g., the conductive heat dissipation structure) may be disposed in the groove formed in the upper surface of the first heat dissipation structure 470 (e.g., the insulating heat dissipation structure).

For example, pressure may be applied in the vertical direction (e.g., the z-axis direction) from the top of the shielding layer 430 (e.g., the shielding film, the shielding plate, or the shielding sheet) toward the processor 492. When pressure is applied in the vertical direction (e.g., the z-axis direction), air present between the first heat dissipation structure 470 (e.g., the insulating heat dissipation structure) and the second heat dissipation structure 480 (e.g., the conductive heat dissipation structure) may escape through the porous adhesive material (e.g. adhesive material 440). As the thickness of the first heat dissipation structure 470 (e.g., the insulating heat dissipation structure) decreases due to the pressure, the first heat dissipation structure 470 (e.g., the insulating heat dissipation structure) may spread in a planar direction, and the composite heat dissipation structure 402 and the adhesive material layer 440 may be bonded and sealed.

A printed circuit board assembly 401 including the heat dissipation structure 402 of the disclosure, and an electronic device 400 including the printed circuit board assembly 401, may improve heat dissipation performance of the heat generated from the processor 492 and the memory 494 under an environment in which high heat generation of about 15 W occurs, as described in Table 2.

For example, as a result of comparing the dynamic thermal management (DTM) timing at which a maximum temperature is reached and a GPU temperature, the DTM timing may be delayed by about 54 to 58 seconds and the temperature of the processor 492 may be reduced by about -5.8°C by applying the heat dissipation structure (#3) of the disclosure compared to comparative examples (#1 and #2).

**[Table 2]**

| *DTM: Dynamic Thermal Management (Performance Limit) | | | | |
|---|---|---|---|---|
| Classification | | DTM arrival time | | Temperature |
| No | AP TIM | Max (sec) | Avg (sec) | GPU (°C) |
| #1 | Insulating &compressible material TIM | 229 | 203 | 94.3 |
| #2 | Conductive material TIM | 249 (+20) | 229 (+26) | 89.8 (-4.5) |
| #3 | Conductive material TIM | 287 (+58) | 257 (+54) | 87.5 (-5.8) |
| | Insulating &compressible material TIM | | | |

| | | | | |
|---|---|---|---|---|
| Insulating &compressible material TIM (5W/mK) Conductive material TIM (38W/mK) | | | | |

A TIM with generally high thermal conductivity contains a large amount of hard conductive fillers, and thus, when excessively compressed, deformation of a smartphone display and a front metal may occur. In addition, around the processor (e.g., an application processor), various electronic elements such as a passive component, a PMIC, and an IC are arranged, and spreading of the conductive fillers may cause a short circuit.

The printed circuit board assembly 401 including the composite heat dissipation structure 402 of the disclosure, and the electronic device 400 including the printed circuit board assembly 401, may prevent a short circuit from occurring between electronic components by disposing the first heat dissipation structure 470 so as to cover the upper surfaces of at least some of the heat-generating components 490 and disposing the second heat dissipation structure 480 (e.g., the conductive heat dissipation structure) so as to cover at least a portion of the upper surface of the first heat dissipation structure 470 (e.g., the insulating heat dissipation structure).

Since the composite heat dissipation structure 402 according to an embodiment of the disclosure has different compressibilities between the first heat dissipation structure 470 (e.g., the insulating heat dissipation structure) and the second heat dissipation structure 480 (e.g., the conductive heat dissipation structure), it may be possible to prevent defects caused by compression during a manufacturing process.

The composite heat dissipation structure 402 according to an embodiment of the disclosure applies a compressible TIM, thereby reducing thermal resistance at an interface between the heat-generating components 490 (e.g., the processor and the memory) and the composite heat dissipation structure 402.

For example, the first heat dissipation structure 470 (e.g., the insulating heat dissipation structure) may be thicker than the second heat dissipation structure 480 (e.g., the conductive heat dissipation structure). For example, the first heat dissipation structure 470 (e.g., the insulating heat dissipation structure) may have a larger area than the second heat dissipation structure 480 (e.g., the conductive heat dissipation structure).

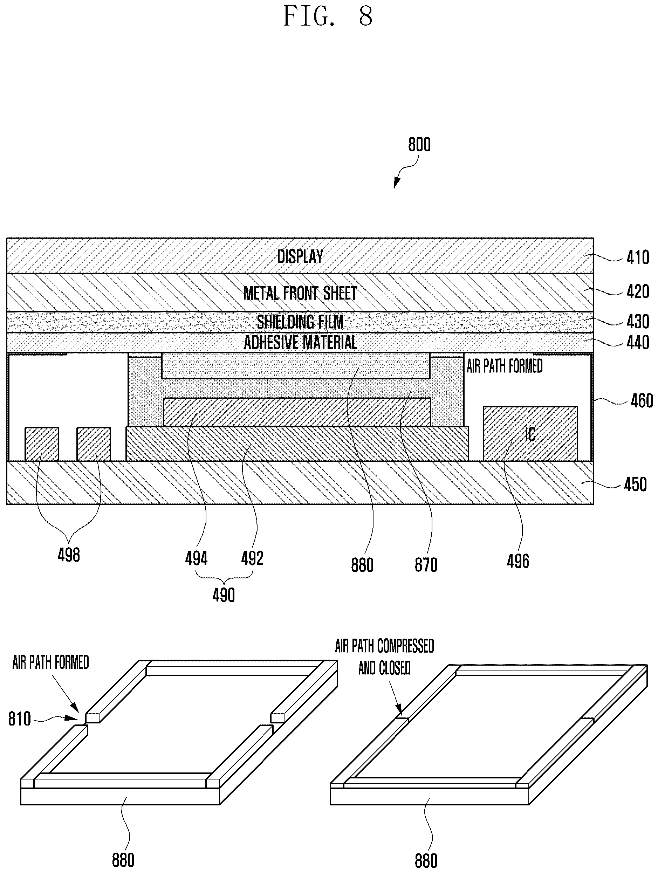

FIG. 8 is a view illustrating a method of forming a heat dissipation structure of a printed circuit board assembly illustrated in FIG. 4.

Referring to FIG. 8, an electronic device 800 (e.g., the electronic device 400 of FIG. 4) according to an embodiment of the disclosure may include a display 410 (e.g., the display module 160 of FIG. 1, the first display 230 (a flexible display) of FIG. 2A, or the display 301 of FIG. 3A), a metal front sheet 420 supporting the display 410, and a printed circuit board assembly 801 (e.g., the printed circuit board assembly 401 of FIG. 4).

According to an embodiment, the printed circuit board assembly 801 may include a shielding layer 430 (e.g., a shielding film, a shielding plate, or a shielding sheet), an adhesive material layer 440 (e.g., an adhesive film, an adhesive plate, or an adhesive sheet), a printed circuit board 450 (e.g., a PCB or a PBA), a shield can 460, a composite heat dissipation structure (e.g., the composite heat dissipation structure 402 of FIG. 4), and electronic components such as heat-generating components 490, an integrated circuits (IC) 496, and other electronic components 498 (e.g., peripheral circuit components or passive components).

According to an embodiment, the electronic components (e.g. heat-generating components 490, the integrated circuit 496, and the other electronic components 498) may be mounted on the printed circuit board 450.

According to an embodiment, the heat-generating components 490 may include a memory 494 (e.g., the memory 130 of FIG. 1 or a DRAM) and a processor 492 (e.g., the processor 120 of FIG. 1). For example, the memory 494 and the processor 492 may be stacked on the printed circuit board 450.

For example, the processor 492 may be mounted on the printed circuit board 450, and the memory 494 may be stacked on the processor 492. However, the disclosure is not limited thereto, and the memory 494 may be disposed on the printed circuit board 450, and the processor 492 may be stacked on the memory 494.

For example, the integrated circuit 496 and the other electronic components 498 may be disposed around the memory 494 and the processor 492.

According to an embodiment, the composite heat dissipation structure 802 may be disposed to at least partially cover the heat generating components 490 (e.g. to at least partially cover the memory 494 and the processor 492) so as to dissipate heat generated from the heat generating components 490 (e.g. memory 494 and the processor 492).

According to an embodiment, the shielding layer 430 (e.g. shielding film) may be disposed to cover the composite heat dissipation structure 802 and the shield can 460.

According to an embodiment, the composite heat dissipation structure 802 may include a first heat dissipation structure 870 (e.g., an insulating heat dissipation structure or a first TIM) and a second heat dissipation structure 880 (e.g., a conductive heat dissipation structure or a second TIM).

For example, the first heat dissipation structure 870 (e.g., the insulating heat dissipation structure) may be disposed to cover at least a portion of the upper surfaces of the heat-generating components 490. The first heat dissipation structure 870 (e.g., the insulating heat dissipation structure) may be disposed to cover upper surfaces of the memory 494 and the processor 492. The upper surfaces may include surfaces facing (or substantially facing) the same direction as the surface of the printed circuit board 450 on which the electronic components are mounted. The upper surfaces may include surfaces not facing (or not substantially facing) the surface of the printed circuit board 450 on which the electronic components are mounted.

For example, the second heat dissipation structure 880 (e.g., the conductive heat dissipation structure) may be disposed to cover at least a portion of an upper surface of the first heat dissipation structure 870 (e.g., the insulating heat dissipation structure).

The first heat dissipation structure 870 may be disposed to at least partially surround the second heat dissipation structure 880. For example, a groove having a predetermined depth may be formed on the upper surface of the first heat dissipation structure 870 (e.g., the insulating heat dissipation structure), and the second heat dissipation structure 880 (e.g., the conductive heat dissipation structure) may be disposed in the groove formed on the upper surface of the first heat dissipation structure 870 (e.g., the insulating heat dissipation structure).

For example, the upper surface of the first heat dissipation structure 870 (e.g., the insulating heat dissipation structure) and the upper surface of the second heat dissipation structure 880 (e.g., the conductive heat dissipation structure) may be disposed to be in contact with a lower surface of the adhesive material layer 440. The lower surface may be a surface facing (or substantially facing) the surface of the printed circuit board 450 on which the electronic components are mounted.

According to an embodiment, the first heat dissipation structure 870 (e.g., the insulating heat dissipation structure) and the second heat dissipation structure 880 (e.g., the conductive heat dissipation structure) of the composite heat dissipation structure 802 may have different compressibilities. For example, the first heat dissipation structure 870 may have a higher compressibility than the second heat dissipation structure 880.

According to an embodiment, the first heat dissipation structure 870 (e.g., the insulating heat dissipation structure) may include a heat spreading (thermal conduction) member, a thermal grease, a heat dissipation paste, or a heat spreading (thermal conduction) paste.

For example, the first heat dissipation structure 870 (e.g., the insulating heat dissipation structure) may include an adhesive material and an (electrically) insulating TIM. The first heat dissipation structure 870 (e.g., the insulating heat dissipation structure) may include a ceramic-based non-conductive filler (e.g., alumina, aluminum nitride, or boron nitride).

For example, the first heat dissipation structure 870 (e.g., an insulating heat dissipation structure) may have a lower thermal conductivity than the second heat dissipation structure 880 (e.g., the conductive heat dissipation structure).

For example, the first heat dissipation structure 870 (e.g., an insulating heat dissipation structure) may have a thermal conductivity of 2 to 4 W/mK.

For example, the first heat dissipation structure 870 (e.g., the insulating heat dissipation structure) may have a compressibility of 15% to 30% under a pressure condition of 10 to 20 psi.

For example, the first heat dissipation structure 870 (e.g., the insulating heat dissipation structure) may have a thickness of 0.1 to 0.3 mm.

According to an embodiment, the second heat dissipation structure 880 (e.g., the conductive heat dissipation structure) may include a heat spreading (thermal conduction) member, a thermal grease, a heat dissipation paste, or a heat spreading (thermal conduction) paste.

For example, the second heat dissipation structure 880 (e.g., the conductive heat dissipation structure) may include an adhesive material and a (electrically) conductive TIM. The second heat dissipation structure 880 (e.g., the conductive heat dissipation structure) may include a carbon-based conductive filler (e.g., carbon nanotube, carbon fiber, graphene, or graphite).

For example, the second heat dissipation structure 880 (e.g., the conductive heat dissipation structure) may have a thermal conductivity of 20 to 40 W/mK.

For example, the second heat dissipation structure 880 (e.g., the conductive heat dissipation structure) may have a compressibility of 0.1% to 15% under a pressure condition of 10 to 20 psi.

For example, the second heat dissipation structure 880 (e.g., the conductive heat dissipation structure) may have a thickness of 0.1 to 0.3 mm.

According to an embodiment, as the power generated from the processor (e.g., an application processor) continuously increases, a TIM having a higher thermal conductivity needs to be applied to effectively remove the high heat generated from the processor (e.g., an application processor). Since higher electrical conductivity also means higher thermal conductivity, a filler having high electrical conductivity may be used as the TIM.

According to an embodiment, in the disclosure, in order to achieve high thermal conductivity, a ceramic-based non-conductive filler (e.g., alumina, aluminum nitride, or boron nitride) may be applied as a TIM of the first heat dissipation structure 870 (e.g., the insulating heat dissipation structure).

According to an embodiment, in the disclosure, in order to achieve high thermal conductivity, a carbon-based conductive filler (e.g., carbon fiber, graphite, carbon nanotube, or graphene) may be applied as a TIM of the second heat dissipation structure 880 (e.g., the conductive heat dissipation structure).

According to an embodiment, in the disclosure, in order to achieve high thermal conductivity, a metal-based conductive filler (e.g., aluminum, copper, or silver) may be applied as a TIM of the second heat dissipation structure 880 (e.g., the conductive heat dissipation structure).

According to an embodiment, in the disclosure, in order to achieve higher thermal conductivity, the first heat dissipation structure 870 (e.g., the insulating heat dissipation structure) and the second heat dissipation structure 880 (e.g., the conductive heat dissipation structure) may be vertically aligned and applied.

For example, in the disclosure, in order to achieve higher thermal conductivity, fillers contained in the first heat dissipation structure 870 (e.g., the insulating heat dissipation structure) may be vertically aligned and applied. The vertical direction may be considered to be the direction perpendicular to the surface of the surface of the printed circuit board 450 on which the electronic components are mounted.

For example, in the disclosure, in order to achieve higher thermal conductivity, fillers contained in the second heat dissipation structure 880 (e.g., the conductive heat dissipation structure) may be vertically aligned and applied.

According to an embodiment, at least a portion of the first heat dissipation structure 870 (e.g., the insulating heat dissipation structure) may include (for example, may be formed or configured to include) an air outlet 810 (air path) so as to allow air present inside the first heat dissipation structure 870 (e.g., the insulating heat dissipation structure) to escape to the outside. For example, the first heat dissipation structure 870 may surround or enclose an area, with the exception of one or more air outlets 810 in the surrounding. The area may be, for example, the groove formed on the upper surface of the first heat dissipation structure 870 to accommodate the second heat dissipation structure 880.

For example, pressure may be applied in the vertical direction (e.g., the z-axis direction or the direction perpendicular to the surface of the printed circuit board 450 on which the electronic components are mounted) to the first heat dissipation structure 870 (e.g., the insulating heat dissipation structure) and the second heat dissipation structure 880 (e.g., the conductive heat dissipation structure). For example, the pressure may be applied when the printed circuit board assembly 801 is assembled and/or mounted in the electronic device 800. When pressure is applied, the first heat dissipation structure 870 (e.g., the insulating heat dissipation structure) may be compressed, causing the air to be discharged to the outside, and the air outlet 810 (air path) may be closed. When pressure is applied in the vertical direction (e.g., the z-axis direction), the air present between the first heat dissipation structure 870 (e.g., the insulating heat dissipation structure) and the second heat dissipation structure 880 (e.g., the conductive heat dissipation structure) may escape, and the composite heat dissipation structure 802 and the adhesive material layer 440 may be bonded and sealed.

The printed circuit board assembly 801 including the composite heat dissipation structure 802 of the disclosure, and the electronic device 800 including the printed circuit board assembly 801, may prevent a short circuit from occurring by disposing the first heat dissipation structure 870 so as to cover the upper surfaces of at least some of the heat-generating components 490 and disposing the second heat dissipation structure 880 (e.g., the conductive heat dissipation structure) so as to cover at least a portion of the upper surface of the first heat dissipation structure 870 (e.g., the insulating heat dissipation structure).

Since the composite heat dissipation structure 802 according to an embodiment of the disclosure has different compressibilities between the first heat dissipation structure 870 (e.g., the insulating heat dissipation structure) and the second heat dissipation structure 880 (e.g., the conductive heat dissipation structure), it may be possible to prevent defects caused by compression during a manufacturing process.

The composite heat dissipation structure 802 according to an embodiment of the disclosure applies a compressible TIM, thereby reducing thermal resistance at an interface between the heat-generating components 490 (e.g., the processor and the memory) and the composite heat dissipation structure 802.

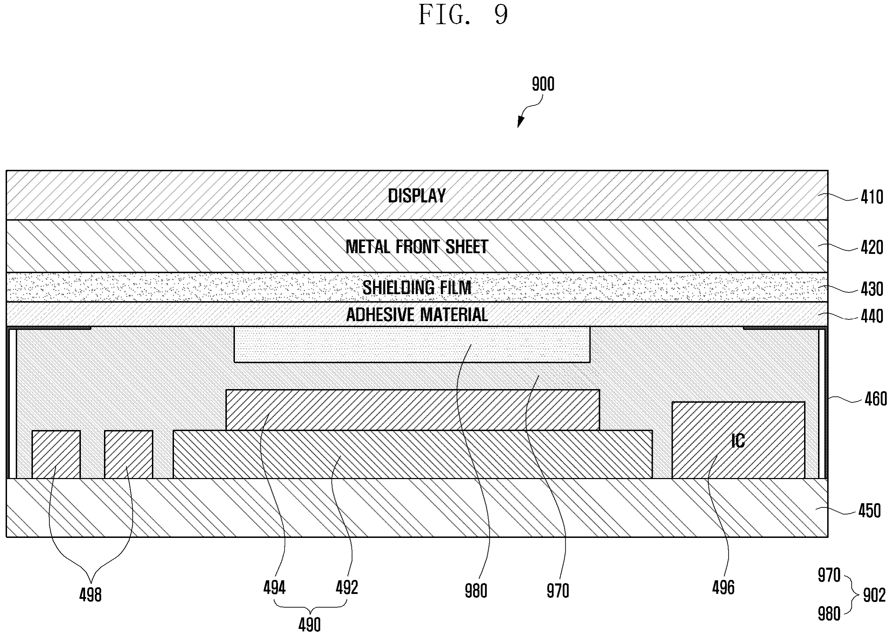

FIG. 9 is a view illustrating a printed circuit board assembly including a heat dissipation structure and an electronic device including the printed circuit board assembly, according to an embodiment of the disclosure.

Referring to FIG. 9, an electronic device 900 (e.g., the electronic device 400 of FIG. 4) according to an embodiment of the disclosure may include a display 410 (e.g., the display module 160 of FIG. 1, the first display 230 (a flexible display) of FIG. 2A, or the display 301 of FIG. 3A), a metal front sheet 420 supporting the display 410, and a printed circuit board assembly 901 (e.g., the printed circuit board assembly 401 of FIG. 4).

According to an embodiment, the printed circuit board assembly 901 may include a shielding layer 430 (e.g., a shielding film, a shielding plate, or a shielding sheet), an adhesive material layer 440 (e.g., an adhesive film, an adhesive plate, or an adhesive sheet), a printed circuit board 450 (e.g., a PCB or a PBA), a shield can 460, a composite heat dissipation structure 902 (e.g., the composite heat dissipation structure 402 of FIG. 4), and electronic components such as heat-generating components 490, an integrated circuit (IC) 496, and other electronic components 498 (e.g., peripheral circuit components or passive components).

According to an embodiment, the electronic components (e.g. the heat-generating components 490, the integrated circuit 496, and the other electronic components 498) may be mounted on the printed circuit board 450.

According to an embodiment, the heat-generating components 490 may include a memory 494 (e.g., the memory 130 of FIG. 1 or a DRAM) and a processor 492 (e.g., the processor 120 of FIG. 1). For example, the memory 494 and the processor 492 may be stacked on the printed circuit board 450.

For example, the processor 492 may be mounted on the printed circuit board 450, and the memory 494 may be stacked on the processor 492. However, the disclosure is not limited thereto, and the memory 494 may be disposed on the printed circuit board 450, and the processor 492 may be stacked on the memory 494.

For example, the integrated circuit 496 and the other electronic components 498 may be disposed around the memory 494 and the processor 492.

According to an embodiment, the composite heat dissipation structure 902 may be disposed to at least partially cover the heat generating components 490 (e.g. to at least partially cover the memory 494 and the processor 492) so as to dissipate heat generated from the heat generating components 490 (e.g. memory 494 and the processor 492).

According to an embodiment, the shielding layer 430 (e.g. shielding film) may be disposed to cover the composite heat dissipation structure 902 and the shield can 460.

According to an embodiment, the composite heat dissipation structure 902 may include a first heat dissipation structure 970 (e.g., an insulating heat dissipation structure or a first TIM) and a second heat dissipation structure 980 (e.g., a conductive heat dissipation structure or a second TIM).

For example, the first heat dissipation structure 970 (e.g., the insulating heat dissipation structure) may be disposed to cover at least a portion of the upper surfaces of the heat-generating components 490. The first heat dissipation structure 970 (e.g., the insulating heat dissipation structure) may be disposed to cover upper surfaces of the memory 494 and the processor 492. The upper surfaces may include surfaces facing (or substantially facing) the same direction as the surface of the printed circuit board 450 on which the electronic components are mounted. The upper surfaces may include surfaces not facing (or not substantially facing) the surface of the printed circuit board 450 on which the electronic components are mounted.

For example, the first heat dissipation structure 970 (e.g., the insulating heat dissipation structure) may be disposed to fill a portion inside the shield can 460, excluding the second heat dissipation structure 980 (e.g., the conductive heat dissipation structure, or the second TIM), the processor 492, the memory 494, the integrated circuit 496, and the electronic components 498. For example, the first heat dissipation structure 970 (e.g., the insulating heat dissipation structure) may be disposed to cover upper surfaces of the processor 492, the memory 494, the integrated circuit 496, and the electronic components 498. For example, the first heat dissipation structure 970 (e.g., the insulating heat dissipation structure) may be disposed to surround a lower surface and side surfaces of the second heat dissipation structure 980 (e.g., the conductive heat dissipation structure or the second TIM). The lower surface may be a surface facing (or substantially facing) the surface of the printed circuit board 450 on which the electronic components are mounted.

For example, the second heat dissipation structure 980 (e.g., the conductive heat dissipation structure) may be disposed to cover at least a portion of an upper surface of the first heat dissipation structure 970 (e.g., the insulating heat dissipation structure).

The first heat dissipation structure 470 may be disposed to at least partially surround the second heat dissipation structure 480. For example, a groove having a predetermined depth may be formed on the upper surface of the first heat dissipation structure 970 (e.g., the insulating heat dissipation structure), and the second heat dissipation structure 980 (e.g., the conductive heat dissipation structure) may be disposed in the groove formed on the upper surface of the first heat dissipation structure 970 (e.g., the insulating heat dissipation structure).

For example, the upper surface of the first heat dissipation structure 970 (e.g., the insulating heat dissipation structure) and the upper surface of the second heat dissipation structure 980 (e.g., the conductive heat dissipation structure) may be disposed to be in contact with a lower surface of the adhesive material layer 440.

According to an embodiment, the first heat dissipation structure 970 (e.g., the insulating heat dissipation structure) and the second heat dissipation structure 980 (e.g., the conductive heat dissipation structure) of the composite heat dissipation structure 902 may have different compressibilities. For example, the first heat dissipation structure 970 may have a higher compressibility than the second heat dissipation structure 980.

According to an embodiment, the first heat dissipation structure 970 (e.g., the insulating heat dissipation structure) may include a heat spreading (thermal conduction) member, a thermal grease, a heat dissipation paste, or a heat spreading (thermal conduction) paste.

For example, the first heat dissipation structure 970 (e.g., the insulating heat dissipation structure) may include an adhesive material and an (electrically) insulating TIM. The first heat dissipation structure 970 (e.g., the insulating heat dissipation structure) may include a ceramic-based non-conductive filler (e.g., alumina, aluminum nitride, or boron nitride).

For example, the first heat dissipation structure 970 (e.g., an insulating heat dissipation structure) may have a lower thermal conductivity than the second heat dissipation structure 980 (e.g., the conductive heat dissipation structure).

For example, the first heat dissipation structure 970 (e.g., an insulating heat dissipation structure) may have a thermal conductivity of 2 to 4 W/mK.

For example, the first heat dissipation structure 970 (e.g., the insulating heat dissipation structure) may have a compressibility of 15% to 30% under a pressure condition of 10 to 20 psi.

For example, the first heat dissipation structure 970 (e.g., the insulating heat dissipation structure) may have a thickness of 0.1 to 0.3 mm.

According to an embodiment, the second heat dissipation structure 980 (e.g., the conductive heat dissipation structure) may include a heat spreading (thermal conduction) member, a thermal grease, a heat dissipation paste, or a heat spreading (thermal conduction) paste.

For example, the second heat dissipation structure 980 (e.g., the conductive heat dissipation structure) may include an adhesive material and a (electrically) conductive TIM. The second heat dissipation structure 980 (e.g., the conductive heat dissipation structure) may include a carbon-based conductive filler (e.g., carbon nanotube, carbon fiber, graphene, or graphite).

For example, the second heat dissipation structure 980 (e.g., the conductive heat dissipation structure) may have a thermal conductivity of 20 to 40 W/mK.

For example, the second heat dissipation structure 980 (e.g., the conductive heat dissipation structure) may have a compressibility of 0.1% to 15% under a pressure condition of 10 to 20 psi.

For example, the second heat dissipation structure 980 (e.g., the conductive heat dissipation structure) may have a thickness of 0.1 to 0.3 mm.

According to an embodiment, as the power generated from the processor (e.g., an application processor) continuously increases, a TIM having a higher thermal conductivity needs to be applied to effectively remove the high heat generated from the processor (e.g., an application processor). Since higher electrical conductivity also means higher thermal conductivity, a filler having high electrical conductivity may be used as the TIM.

According to an embodiment, in the disclosure, in order to achieve high thermal conductivity, a ceramic-based non-conductive filler (e.g., alumina, aluminum nitride, or boron nitride) may be applied as a TIM of the first heat dissipation structure 970 (e.g., the insulating heat dissipation structure).

According to an embodiment, in the disclosure, in order to achieve high thermal conductivity, a carbon-based conductive filler (e.g., carbon fiber, graphite, carbon nanotube, or graphene) may be applied as a TIM of the second heat dissipation structure 980 (e.g., the conductive heat dissipation structure).

According to an embodiment, in the disclosure, in order to achieve high thermal conductivity, a metal-based conductive filler (e.g., aluminum, copper, or silver) may be applied as a TIM of the second heat dissipation structure 980 (e.g., the conductive heat dissipation structure).

According to an embodiment, in the disclosure, in order to achieve higher thermal conductivity, the first heat dissipation structure 970 (e.g., the insulating heat dissipation structure) and the second heat dissipation structure 980 (e.g., the conductive heat dissipation structure) may be vertically aligned and applied. The vertical direction may be considered to be the direction perpendicular to the surface of the surface of the printed circuit board 450 on which the electronic components are mounted.

For example, in the disclosure, in order to achieve higher thermal conductivity, fillers contained in the first heat dissipation structure 970 (e.g., the insulating heat dissipation structure) may be vertically aligned and applied.

For example, in the disclosure, in order to achieve higher thermal conductivity, fillers contained in the second heat dissipation structure 980 (e.g., the conductive heat dissipation structure) may be vertically aligned and applied.

The printed circuit board assembly 901 including the composite heat dissipation structure 902 of the disclosure, and the electronic device 900 including the printed circuit board assembly 901, may prevent a short circuit from occurring between electronic components by disposing the first heat dissipation structure 970 so as to cover the upper surfaces of at least some of the heat-generating components 490 and disposing the second heat dissipation structure 980 (e.g., the conductive heat dissipation structure) so as to cover at least a portion of the upper surface of the first heat dissipation structure 970 (e.g., the insulating heat dissipation structure).

Since the composite heat dissipation structure 902 according to an embodiment of the disclosure has different compressibilities between the first heat dissipation structure 970 (e.g., the insulating heat dissipation structure) and the second heat dissipation structure 980 (e.g., the conductive heat dissipation structure), it may be possible to prevent defects caused by compression during a manufacturing process.

The composite heat dissipation structure 902 according to an embodiment of the disclosure applies a compressible TIM, thereby reducing thermal resistance at an interface between the heat-generating components (e.g., the processor and the memory) and the composite heat dissipation structure.

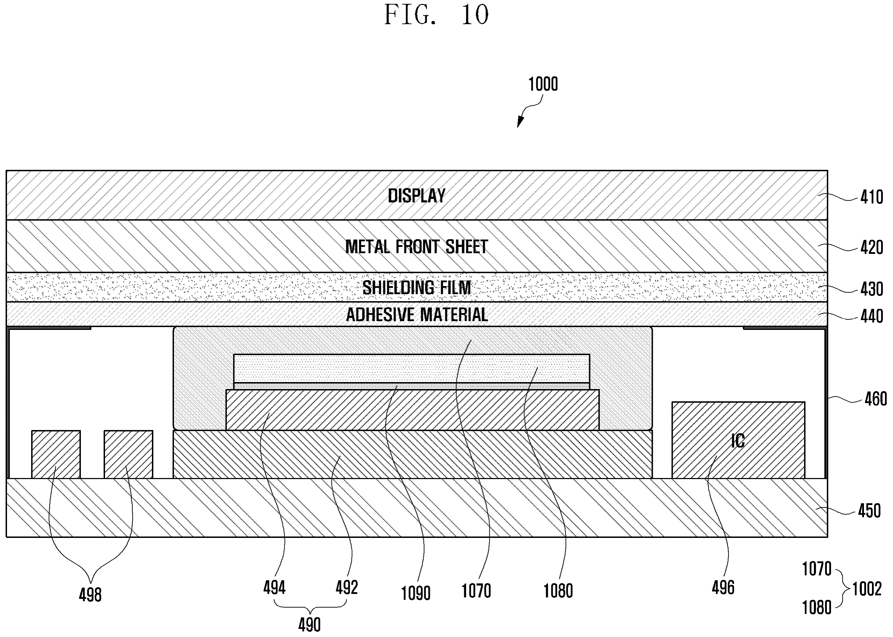

FIG. 10 is a view illustrating a printed circuit board assembly including a heat dissipation structure and an electronic device including the printed circuit board assembly, according to an embodiment of the disclosure.

Referring to FIG. 10, an electronic device 1000 (e.g., the electronic device 400 of FIG. 4) according to an embodiment of the disclosure may include a display 410 (e.g., the display module 160 of FIG. 1, the first display 230 (a flexible display) of FIG. 2A, or the display 301 of FIG. 3A), a metal front sheet 420 supporting the display 410, and a printed circuit board assembly 1001 (e.g., the printed circuit board assembly 401 of FIG. 4).

According to an embodiment, the printed circuit board assembly 1001 may include a shielding layer 430 (e.g., a shielding film, a shielding plate, or a shielding sheet), an adhesive material layer 440 (e.g., an adhesive film, an adhesive plate, or an adhesive sheet), a printed circuit board 450 (e.g., a PCB or a PBA), a shield can 460, a composite heat dissipation structure 1002 (e.g., the composite heat dissipation structure 402 of FIG. 4), and electronic components such as heat-generating components 490, an integrated circuit (IC) 496, and other electronic components 498 (e.g., peripheral circuit components or passive components).

According to an embodiment, the electronic components (e.g. heat-generating components 490, the integrated circuit 496, and the other electronic components 498) may be mounted on the printed circuit board 450.

According to an embodiment, the heat-generating components 490 may include a memory 494 (e.g., the memory 130 of FIG. 1 or a DRAM) and a processor 492 (e.g., the processor 120 of FIG. 1). For example, the memory 494 and the processor 492 may be stacked on the printed circuit board 450.

For example, the processor 492 may be mounted on the printed circuit board 450, and the memory 494 may be stacked on the processor 492. However, the disclosure is not limited thereto, and the memory 494 may be disposed on the printed circuit board 450, and the processor 492 may be stacked on the memory 494.

For example, the integrated circuit 496 and the other electronic components 498 may be disposed around the memory 494 and the processor 492.

According to an embodiment, the composite heat dissipation structure 1002 may be disposed to at least partially cover the heat generating components 490 (e.g. to at least partially cover the memory 494 and the processor 492) so as to dissipate heat generated from the heat generating components 490 (e.g. memory 494 and the processor 492).

According to an embodiment, the shielding layer 430 (e.g. shielding film) may be disposed to cover the composite heat dissipation structure 1002 and the shield can 460.

According to an embodiment, the composite heat dissipation structure 1002 may include a first heat dissipation structure 1070 (e.g., an (electrically) insulating heat dissipation structure or a first TIM) and a second heat dissipation structure 1080 (e.g., a (electrically) conductive heat dissipation structure or a second TIM).

For example, the second heat dissipation structure 1080 (e.g., the conductive heat dissipation structure) may be disposed to cover at least a portion of the upper surfaces of the heat-generating components 490. The second heat dissipation structure 1080 (e.g., the conductive heat dissipation structure) may be disposed to cover at least a portion of the upper surface of the memory 494. The upper surfaces may include surfaces facing (or substantially facing) the same direction as the surface of the printed circuit board 450 on which the electronic components are mounted. The upper surfaces may include surfaces not facing (or not substantially facing) the surface of the printed circuit board 450 on which the electronic components are mounted

For example, an adhesive layer 1090 may be disposed between the upper surface of the memory 494 and the lower surface of the second heat dissipation structure 1080 (e.g., the conductive heat dissipation structure). Without being limited thereto, the upper surface of the memory 494 and the lower surface of the second heat dissipation structure 1080 (e.g., the conductive heat dissipation structure) may be disposed to be in direct contact without the adhesive layer 1090. The lower surface may be a surface facing (or substantially facing) the surface of the printed circuit board 450 on which the electronic components are mounted.

For example, the first heat dissipation structure 1070 (e.g., the insulating heat dissipation structure) may be disposed to surround (or at least partially surround) the second heat dissipation structure 1080 (e.g., the conductive heat dissipation structure). For example, the first heat dissipation structure 1070 (e.g., the insulating heat dissipation structure) may be disposed to cover upper surfaces of the second heat dissipation structure 1080 (e.g., the conductive heat dissipation structure). For example, at least a portion of the first heat dissipation structure 1070 may be disposed between the second heat dissipation structure 1080 and the shielding layer 430/adhesive material 440. The first heat dissipation structure 1070 (e.g., the insulating heat dissipation structure) may be disposed to cover the processor 492 and the memory 494. For example, the first heat dissipation structure 1070 (e.g., the insulating heat dissipation structure) may be disposed to cover upper surfaces of the processor 492 and the memory 494.

For example, the second heat dissipation structure 1080 (e.g., the conductive heat dissipation structure) may be sealed by the first heat dissipation structure 1070 (e.g., the insulating heat dissipation structure), and the first heat dissipation structure 1070 (e.g., the insulating heat dissipation structure) may be disposed to cover the processor 492 and the memory 494. For example, the first heat dissipation structure 1070 (e.g., the insulating heat dissipation structure) may be disposed to cover upper surfaces of the processor 492 and the memory 494.

According to an embodiment, the first heat dissipation structure 1070 (e.g., the insulating heat dissipation structure) and the second heat dissipation structure 1080 (e.g., the conductive heat dissipation structure) of the composite heat dissipation structure 1002 may have different compressibilities. For example, the first heat dissipation structure 1070 may have a higher compressibility than the second heat dissipation structure 1080.

According to an embodiment, the first heat dissipation structure 1070 (e.g., the insulating heat dissipation structure) may include a heat spreading (thermal conduction) member, a thermal grease, a heat dissipation paste, or a heat spreading (thermal conduction) paste.

For example, the first heat dissipation structure 1070 (e.g., the insulating heat dissipation structure) may include an adhesive material and an (electrically) insulating TIM. The first heat dissipation structure 1070 (e.g., the insulating heat dissipation structure) may include a ceramic-based non-conductive filler (e.g., alumina, aluminum nitride, or boron nitride).

For example, the first heat dissipation structure 1070 (e.g., an insulating heat dissipation structure) may have a lower thermal conductivity than the second heat dissipation structure 1080 (e.g., the conductive heat dissipation structure).

For example, the first heat dissipation structure 1070 (e.g., an insulating heat dissipation structure) may have a thermal conductivity of 2 to 4 W/mK.

For example, the first heat dissipation structure 1070 (e.g., the insulating heat dissipation structure) may have a compressibility of 15% to 30% under a pressure condition of 10 to 20 psi.

For example, the first heat dissipation structure 1070 (e.g., the insulating heat dissipation structure) may have a thickness of 0.1 to 0.3 mm.

According to an embodiment, the second heat dissipation structure 1080 (e.g., the conductive heat dissipation structure) may include a heat spreading (thermal conduction) member, a thermal grease, a heat dissipation paste, or a heat spreading (thermal conduction) paste.

For example, the second heat dissipation structure 1080 (e.g., the conductive heat dissipation structure) may include an adhesive material and a (electrically) conductive TIM. The second heat dissipation structure 1080 (e.g., the conductive heat dissipation structure) may include a carbon-based conductive filler (e.g., carbon nanotube, carbon fiber, graphene, or graphite).

For example, the second heat dissipation structure 1080 (e.g., the conductive heat dissipation structure) may have a thermal conductivity of 20 to 40 W/mK.

For example, the second heat dissipation structure 1080 (e.g., the conductive heat dissipation structure) may have a compressibility of 0.1% to 15% under a pressure condition of 10 to 20 psi.

For example, the second heat dissipation structure 1080 (e.g., the conductive heat dissipation structure) may have a thickness of 0.1 to 0.3 mm.

According to an embodiment, as the power generated from the processor (e.g., an application processor) continuously increases, a TIM having a higher thermal conductivity needs to be applied to effectively remove the high heat generated from the processor (e.g., an application processor). Since higher electrical conductivity also means high thermal conductivity, a filler having higher electrical conductivity may be used as the TIM.

According to an embodiment, in the disclosure, in order to achieve high thermal conductivity, a ceramic-based non-conductive filler (e.g., alumina, aluminum nitride, or boron nitride) may be applied as a TIM of the first heat dissipation structure 1070 (e.g., the insulating heat dissipation structure).

According to an embodiment, in the disclosure, in order to achieve high thermal conductivity, a carbon-based conductive filler (e.g., carbon fiber, graphite, carbon nanotube, or graphene) may be applied as a TIM of the second heat dissipation structure 1080 (e.g., the conductive heat dissipation structure).

According to an embodiment, in the disclosure, in order to achieve high thermal conductivity, a metal-based conductive filler (e.g., aluminum, copper, or silver) may be applied as a TIM of the second heat dissipation structure 1080 (e.g., the conductive heat dissipation structure).

According to an embodiment, in the disclosure, in order to achieve higher thermal conductivity, the first heat dissipation structure 1070 (e.g., the insulating heat dissipation structure) and the second heat dissipation structure 1080 (e.g., the conductive heat dissipation structure) may be vertically aligned and applied. The vertical direction may be considered to be the direction perpendicular to the surface of the surface of the printed circuit board 450 on which the electronic components are mounted.

For example, in the disclosure, in order to achieve higher thermal conductivity, fillers contained in the first heat dissipation structure 1070 (e.g., the insulating heat dissipation structure) may be vertically aligned and applied.

For example, in the disclosure, in order to achieve higher thermal conductivity, fillers contained in the second heat dissipation structure 1080 (e.g., the conductive heat dissipation structure) may be vertically aligned and applied.

Since the composite heat dissipation structure 1002 according to an embodiment of the disclosure has different compressibilities between the first heat dissipation structure 1070 (e.g., the insulating heat dissipation structure) and the second heat dissipation structure 1080 (e.g., the conductive heat dissipation structure), it may be possible to prevent defects caused by compression during a manufacturing process.

The composite heat dissipation structure 1002 according to an embodiment of the disclosure applies a compressible TIM, thereby reducing thermal resistance at an interface between the heat-generating components 490 (e.g., the processor and the memory) and the composite heat dissipation structure 1002.

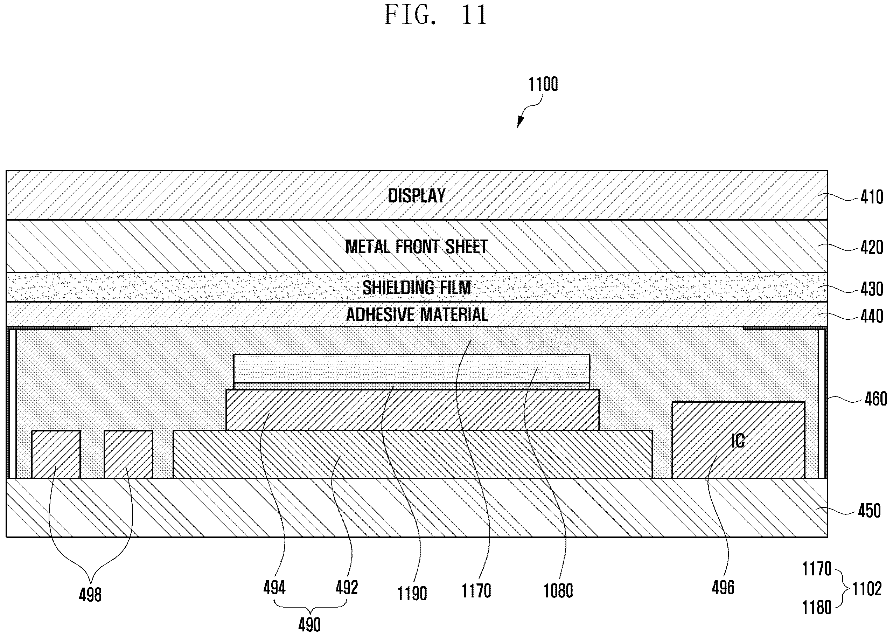

FIG. 11 is a view illustrating a printed circuit board assembly including a heat dissipation structure and an electronic device including the printed circuit board assembly, according to an embodiment of the disclosure.

Referring to FIG. 11, an electronic device 1100 (e.g., the electronic device 400 of FIG. 4) according to an embodiment of the disclosure may include a display 410 (e.g., the display module 160 of FIG. 1, the first display 230 (a flexible display) of FIG. 2A, or the display 301 of FIG. 3A), a metal front sheet 420 supporting the display 410, and a printed circuit board assembly 1101 (e.g., the printed circuit board assembly 401 of FIG. 4).

According to an embodiment, the printed circuit board assembly 1101 may include a shielding layer 430 (e.g., a shielding film, a shielding plate, or a shielding sheet), an adhesive material layer 440 (e.g., an adhesive film, an adhesive plate, or an adhesive sheet), a printed circuit board 450 (e.g., a PCB or a PBA), a shield can 460, a composite heat dissipation structure 1102 (e.g., the composite heat dissipation structure 402 of FIG. 4), and electronic components such as heat-generating components 490, an integrated circuit (IC) 496, and other electronic components 498 (e.g., peripheral circuit components or passive components).

According to an embodiment, the electronic components (e.g. heat-generating components 490, the integrated circuit 496, and the other electronic components 498) may be mounted on the printed circuit board 450.

According to an embodiment, the heat-generating components 490 may include a memory 494 (e.g., the memory 130 of FIG. 1 or a DRAM) and a processor 492 (e.g., the processor 120 of FIG. 1). For example, the memory 494 and the processor 492 may be stacked on the printed circuit board 450.

For example, the processor 492 may be mounted on the printed circuit board 450, and the memory 494 may be stacked on the processor 492. However, the disclosure is not limited thereto, and the memory 494 may be disposed on the printed circuit board 450, and the processor 492 may be stacked on the memory 494.

For example, the integrated circuit 496 and the other electronic components 498 may be disposed around the memory 494 and the processor 492.

According to an embodiment, the composite heat dissipation structure 1102 may be disposed to at least partially cover the memory 494 and the processor 492 so as to dissipate heat generated from the memory 494 and the processor 492.

According to an embodiment, the shielding layer 430 (e.g. shielding film) may be disposed to cover the composite heat dissipation structure 1102 and the shield can 460.

According to an embodiment, the composite heat dissipation structure 1102 may include a first heat dissipation structure 1170 (e.g., an (electrically) insulating heat dissipation structure or a first TIM) and a second heat dissipation structure 1180 (e.g., a (electrically) conductive heat dissipation structure or a second TIM).

For example, the second heat dissipation structure 1180 (e.g., the conductive heat dissipation structure) may be disposed to cover at least a portion of the upper surfaces of the heat-generating components 490. The second heat dissipation structure 1180 (e.g., the conductive heat dissipation structure) may be disposed to cover at least a portion of the upper surface of the memory 494. The upper surfaces may include surfaces facing (or substantially facing) the same direction as the surface of the printed circuit board 450 on which the electronic components are mounted. The upper surfaces may include surfaces not facing (or not substantially facing) the surface of the printed circuit board 450 on which the electronic components are mounted

For example, an adhesive layer 1190 may be disposed between the upper surface of the memory 494 and the lower surface of the second heat dissipation structure 1180 (e.g., the conductive heat dissipation structure). Without being limited thereto, the upper surface of the memory 494 and the lower surface of the second heat dissipation structure 1180 (e.g., the conductive heat dissipation structure) may be disposed to be in direct contact without the adhesive layer 1190. The lower surface may be a surface facing (or substantially facing) the surface of the printed circuit board 450 on which the electronic components are mounted.

For example, the first heat dissipation structure 1170 (e.g., the insulating heat dissipation structure) may be disposed to surround (or at least partially surround) the second heat dissipation structure 1180 (e.g., the conductive heat dissipation structure). For example, the first heat dissipation structure 1170 (e.g., the insulating heat dissipation structure) may be disposed to cover upper surfaces of the second heat dissipation structure 1180 (e.g., the conductive heat dissipation structure). For example, at least a portion of the first heat dissipation structure 1170 may be disposed between the second heat dissipation structure 1180 and the shielding layer 430/adhesive material 440. The first heat dissipation structure 1170 (e.g., the insulating heat dissipation structure) may be disposed to cover the processor 492 and the memory 494. For example, the first heat dissipation structure 1170 (e.g., the insulating heat dissipation structure) may be disposed to cover upper surfaces of the processor 492 and the memory 494.

For example, the first heat dissipation structure 1170 (e.g., the insulating heat dissipation structure) may be disposed to cover the upper surfaces of the integrated circuit 496, and the electronic components 498.

For example, the first heat dissipation structure 1170 (e.g., the insulating heat dissipation structure) may be disposed to fill a portion inside the shield can 460, excluding the second heat dissipation structure 1180 (e.g., the conductive heat dissipation structure), the processor 492, the memory 494, the integrated circuit 496, and the electronic components 498. For example, the first heat dissipation structure 1170 (e.g., the insulating heat dissipation structure) may be seal the second heat dissipation structure 1080 (e.g., the conductive heat dissipation structure). The first heat dissipation structure 1170 (e.g., the insulating heat dissipation structure) may be disposed to cover the processor 492, the memory 494, the integrated circuit (IC) 496, and the other electronic components 498 so as to prevent a short circuit from occurring among the processor 492, the memory 494, the integrated circuit 496, and the other electronic components 498.

For example, the second heat dissipation structure 1180 (e.g., the conductive heat dissipation structure) may be sealed by the first heat dissipation structure 1170 (e.g., the insulating heat dissipation structure), and the first heat dissipation structure 1170 (e.g., the insulating heat dissipation structure) may be disposed to cover the upper surfaces of the integrated circuit 496 and the other electronic components 498, thereby preventing a short circuit from occurring between the processor 492, the memory 494, the integrated circuit 496, and the other electronic components 498 by the second heat dissipation structure 1180 (e.g., the conductive heat dissipation structure).

According to an embodiment, the first heat dissipation structure 1170 (e.g., the insulating heat dissipation structure) and the second heat dissipation structure 1180 (e.g., the conductive heat dissipation structure) of the composite heat dissipation structure 1102 may have different compressibilities. For example, the first heat dissipation structure 1170 may have a higher compressibility than the second heat dissipation structure 1180.

According to an embodiment, the first heat dissipation structure 1170 (e.g., the insulating heat dissipation structure) may include a heat spreading (thermal conduction) member, a thermal grease, a heat dissipation paste, or a heat spreading (thermal conduction) paste.

For example, the first heat dissipation structure 1170 (e.g., the insulating heat dissipation structure) may include an adhesive material and an (electrically) insulating TIM. The first heat dissipation structure 1170 (e.g., the insulating heat dissipation structure) may include a ceramic-based non-conductive filler (e.g., alumina, aluminum nitride, or boron nitride).

For example, the first heat dissipation structure 1170 (e.g., an insulating heat dissipation structure) may have a lower thermal conductivity than the second heat dissipation structure 1180 (e.g., the conductive heat dissipation structure).

For example, the first heat dissipation structure 1170 (e.g., an insulating heat dissipation structure) may have a thermal conductivity of 2 to 4 W/mK.

For example, the first heat dissipation structure 1170 (e.g., the insulating heat dissipation structure) may have a compressibility of 15% to 30% under a pressure condition of 10 to 20 psi.

For example, the first heat dissipation structure 1170 (e.g., the insulating heat dissipation structure) may have a thickness of 0.1 to 0.3 mm.

According to an embodiment, the second heat dissipation structure 1180 (e.g., the conductive heat dissipation structure) may include a heat spreading (thermal conduction) member, a thermal grease, a heat dissipation paste, or a heat spreading (thermal conduction) paste.

For example, the second heat dissipation structure 1180 (e.g., the conductive heat dissipation structure) may include an adhesive material and a (electrically) conductive TIM. The second heat dissipation structure 1180 (e.g., the conductive heat dissipation structure) may include a carbon-based conductive filler (e.g., carbon nanotube, carbon fiber, graphene, or graphite).

For example, the second heat dissipation structure 1180 (e.g., the conductive heat dissipation structure) may have a thermal conductivity of 20 to 40 W/mK.

For example, the second heat dissipation structure 1180 (e.g., the conductive heat dissipation structure) may have a compressibility of 0.1% to 15% under a pressure condition of 10 to 20 psi.

For example, the second heat dissipation structure 1180 (e.g., the conductive heat dissipation structure) may have a thickness of 0.1 to 0.2 mm.

According to an embodiment, as the power generated from the processor (e.g., an application processor) continuously increases, a TIM having a higher thermal conductivity needs to be applied to effectively remove the high heat generated from the processor (e.g., an application processor). Since higher electrical conductivity also means higher thermal conductivity, a filler having high electrical conductivity may be used as the TIM.

According to an embodiment, in the disclosure, in order to achieve high thermal conductivity, a ceramic-based non-conductive filler (e.g., alumina, aluminum nitride, or boron nitride) described in Table 1 may be applied as a TIM of the first heat dissipation structure 1170 (e.g., the insulating heat dissipation structure).

According to an embodiment, in the disclosure, in order to achieve high thermal conductivity, a carbon-based conductive filler (e.g., carbon fiber, graphite, carbon nanotube, or graphene) described in Table 1 may be applied as a TIM of the second heat dissipation structure 1180 (e.g., the conductive heat dissipation structure).

According to an embodiment, in the disclosure, in order to achieve high thermal conductivity, a metal-based conductive filler (e.g., aluminum, copper, or silver) described in Table 1 may be used as a TIM of the second heat dissipation structure 1180 (e.g., the conductive heat dissipation structure).

According to an embodiment, in the disclosure, in order to achieve higher thermal conductivity, the first heat dissipation structure 1170 (e.g., the insulating heat dissipation structure) and the second heat dissipation structure 1180 (e.g., the conductive heat dissipation structure) may be vertically aligned and applied.

For example, in the disclosure, in order to achieve higher thermal conductivity, fillers contained in the first heat dissipation structure 1170 (e.g., the insulating heat dissipation structure) may be vertically aligned and applied. The vertical direction may be considered to be the direction perpendicular to the surface of the surface of the printed circuit board 450 on which the electronic components are mounted.

For example, in the disclosure, in order to achieve higher thermal conductivity, fillers contained in the second heat dissipation structure 1180 (e.g., the conductive heat dissipation structure) may be vertically aligned and applied.

Since the composite heat dissipation structure 1102 according to an embodiment of the disclosure has different compressibilities between the first heat dissipation structure 1170 (e.g., the insulating heat dissipation structure) and the second heat dissipation structure 1180 (e.g., the conductive heat dissipation structure), it may be possible to prevent defects caused by compression during a manufacturing process.

The composite heat dissipation structure 1102 according to an embodiment of the disclosure applies a compressible TIM, thereby reducing thermal resistance at an interface between the heat-generating components 490 (e.g., the processor and the memory) and the composite heat dissipation structure 1102.

An electronic device (e.g., the electronic device 400 of FIG. 4) according to an embodiment of the disclosure may include a printed circuit board (e.g., the printed circuit board 450 of FIG. 4) on which electronic components (e.g., a processor 492, a memory 494, an integrated circuit 496, and electronic components 498 of FIG. 4) are mounted, a shield can (e.g., the shield can 460 of FIG. 4) disposed to shield the electronic components 492, 494, 496, and 498, a composite heat dissipation structure (e.g., the composite heat dissipation structure 402 of FIG. 4, the composite heat dissipation structure 802 of FIG. 8, the composite heat dissipation structure 902 of FIG. 9, the composite heat dissipation structure 1002 of FIG. 10, or the composite heat dissipation structure 1102 of FIG. 11) disposed over the electronic components 492, 494, 496, and 498, a shielding film (e.g., the shielding film 430 of FIG. 4) disposed over the composite heat dissipation structure 402, 802, 902, 1002, or 1102, and a display (e.g., the display 410 of FIG. 4) disposed on the shielding film 430.

According to an embodiment, the composite heat dissipation structure 402, 802, 902, 1002, or 1102 may include a first heat dissipation structure 470, 870, 970, 1070, or 1170 including an insulating and compressible material and a second heat dissipation structure 480, 880, 980, 1080, or 1180 including a conductive material.

According to an embodiment, the first heat dissipation structure 470, 870, 970, 1070, or 1170 may include a ceramic-based filler.

According to an embodiment, the first heat dissipation structure 470, 870, 970, 1070, or 1170 may have a thermal conductivity of 2 to 4 W/mK, a compressibility of 15% to 30% at a pressure of 10 to 20 psi, and a thickness of 0.1 to 0.3 mm.

According to an embodiment, the second heat dissipation structure 480, 880, 980, 1080, or 1180 may include a carbon-based conductive filler.

According to an embodiment, the second heat dissipation structure 480, 880, 980, 1080, or 1180 may have a thermal conductivity of 20 to 40 W/mK, a compressibility of 0.1% to 15% at a pressure of 10 to 20 psi, and a thickness of 0.1 to 0.3 mm.

According to an embodiment, a porous conductive adhesive material 440 may be disposed on a bottom surface of the shielding film 430.

According to an embodiment, the first heat dissipation structure 470, 870, 970, 1070, or 1170 may be disposed over the electronic components 492, 494, 496, and 498. The second heat dissipation structure 480, 880, 980, 1080, or 1180 may be disposed over the first heat dissipation structure 470, 870, 970, 1070, or 1170. The shielding film 430 may be disposed over the second heat dissipation structure 480, 880, 980, 1080, or 1180.

According to an embodiment, the second heat dissipation structure 480, 880, 980, 1080, or 1180 may be disposed over the electronic components 492, 494, 496, and 498. The first heat dissipation structure 470, 870, 970, 1070, or 1170 may be disposed over the second heat dissipation structure 480, 880, 980, 1080, or 1180. The shielding film 430 may be disposed over the first heat dissipation structure 470, 870, 970, 1070, or 1170.

According to an embodiment, at least a portion of the composite heat dissipation structure 402, 802, 902, 1002, or 1102 may be disposed to cover an upper portion of at least some of the electronic components 492, 494, 496, and 498.

According to an embodiment, at least a portion of the composite heat dissipation structure 402, 802, 902, 1002, or 1102 may be disposed to cover an upper portion of all of the electronic components 492, 494, 496, and 498.

A printed circuit board assembly (e.g., the printed circuit board assembly 401 of FIG. 4, 801 of FIG. 8, 901 of FIG. 9, 1001 of FIG. 10, or 1101 of FIG. 11) according to an embodiment of the disclosure may include a printed circuit board 450 on which electronic components 492, 494, 496, and 498 are mounted, a shield can 460 disposed to shield the electronic components 492, 494, 496, and 498, a composite heat dissipation structure 402, 802, 902, 1002, or 1102 disposed over the electronic components 492, 494, 496, and 498, and a shielding film 430 disposed over the composite heat dissipation structure 402, 802, 902, 1002, or 1102.

According to an embodiment, the composite heat dissipation structure 402, 802, 902, 1002, or 1102 may include a first heat dissipation structure 470, 870, 970, 1070, or 1170 including an insulating and compressible material, and a second heat dissipation structure 480, 880, 980, 1080, or 1180 including a conductive material.

According to an embodiment, the first heat dissipation structure 470, 870, 970, 1070, or 1170 may include a ceramic-based conductive filler. The first heat dissipation structure 470, 870, 970, 1070, or 1170 may have a thermal conductivity of 2 to 4 W/mK, a compressibility of 15% to 30% at a pressure of 10 to 20 psi, and a thickness of 0.1 to 0.3 mm.

According to an embodiment, the second heat dissipation structure 480, 880, 980, 1080, or 1180 may include a carbon-based conductive filler. The second heat dissipation structure 480, 880, 980, 1080, or 1180 may have a thermal conductivity of 20 to 40 W/mK, a compressibility of 0.1% to 15% at a pressure of 10 to 20 psi, and a thickness of 0.1 to 0.3 mm.

According to an embodiment, the first heat dissipation structure 470, 870, 970, 1070, or 1170 may include a ceramic-based filler.

According to an embodiment, the second heat dissipation structure 480, 880, 980, 1080, or 1180 may include a carbon-based conductive filler.

According to an embodiment, the second heat dissipation structure 480, 880, 980, 1080, or 1180 may be disposed over the electronic components 492, 494, 496, and 498. The first heat dissipation structure 470, 870, 970, 1070, or 1170 may be disposed over the second heat dissipation structure 480, 880, 980, 1080, or 1180. The shielding film 430 may be disposed over the first heat dissipation structure 470, 870, 970, 1070, or 1170.

According to an embodiment, at least a portion of the composite heat dissipation structure 402, 802, 902, 1002, or 1102 may be disposed to cover an upper portion of at least some of the electronic components 492, 494, 496, and 498.

According to an embodiment, at least a portion of the composite heat dissipation structure 402, 802, 902, 1002, or 1102 may be disposed to cover an upper portion of all of the electronic components 492, 494, 496, and 498.

In a first example, there is provided an electronic device (e.g. 400) comprising: a printed circuit board (e.g. 450) on which electronic components (e.g. 492, 494, 496, 498) are mounted; a shield can (e.g. 460) disposed to shield the electronic components (e.g. 492, 494, 496, 498); a composite heat dissipation structure (e.g. 402, 802, 902, 1002, 1102) disposed over the electronic components; a shielding film (e.g. 430) disposed over the composite heat dissipation structure; and a display (e.g. 410) disposed on the shielding film.

In a second example, there is provided the electronic device of the first example, wherein the composite heat dissipation structure comprises: a first heat dissipation structure (e.g. 470, 870, 970, 1070, 1170) comprising an insulating and compressible material; and a second heat dissipation structure (e.g. 480, 880, 980, 1080, 1180) comprising a conductive material.

In a third example, there is provided the electronic device of the second example, wherein the first heat dissipation structure comprises a ceramic-based filler.

In a fourth example, there is provided the electronic device of the third example, wherein the first heat dissipation structure has a thermal conductivity of 2 to 4 W/mK, a compressibility of 15% to 30% at a pressure of 10 to 20 psi, and a thickness of 0.1 to 0.3 mm.

In a fifth example, there is provided the electronic device of the second example, wherein the second heat dissipation structure comprises a carbon-based conductive filler.

In a sixth example, there is provided the electronic device of the fifth example, wherein the second heat dissipation structure has a thermal conductivity of 20 to 40 W/mK, a compressibility of 0.1% to 15% at a pressure of 10 to 20 psi, and a thickness of 0.1 to 0.3 mm.

In a seventh example, there is provided the electronic device of the second example, wherein a porous conductive adhesive material (e.g. 440) is disposed on a bottom surface of the shielding film.

In an eighth example, there is provided the electronic device of the second example, wherein the first heat dissipation structure is disposed over the electronic components, wherein the second heat dissipation structure is disposed over the first heat dissipation structure, and wherein the shielding film is disposed over the second heat dissipation structure.

In a ninth example, there is provided the electronic device of the second example, wherein the second heat dissipation structure is disposed over the electronic components, wherein the first heat dissipation structure is disposed over the second heat dissipation structure, and wherein the shielding film is disposed over the first heat dissipation structure.

In a tenth example, there is provided the electronic device of the second example, wherein at least a portion of the composite heat dissipation structure is disposed to cover an upper portion of at least some of the electronic components.

In an eleventh example, there is provided the electronic device of the second example, wherein at least a portion of the composite heat dissipation structure is disposed to cover an upper portion of all of the electronic components.

In a twelfth example, there is provided a printed circuit board assembly (e.g. 401, 801, 901, 1001, 1101) comprising: a printed circuit board (e.g. 450) on which electronic components (e.g. 492, 494, 496, 498) are mounted; a shield can (e.g. 460) disposed to shield the electronic components; a composite heat dissipation structure (e.g. 402, 802, 902, 1002, 1102) disposed over the electronic components; and a shielding film (e.g. 430) disposed over the composite heat dissipation structure.

In a thirteenth example, there is provided the electronic device of the twelfth example, wherein the composite heat dissipation structure comprises: a first heat dissipation structure (e.g. 470, 870, 970, 1070, 1170) comprising an insulating and compressible material; and a second heat dissipation structure (e.g. 480, 880, 980, 1080, 1180) comprising a conductive material.

In a fourteenth example, there is provided the electronic device of the thirteenth example, wherein the first heat dissipation structure comprises a ceramic-based filler, and wherein the first heat dissipation structure has a thermal conductivity of 2 to 4 W/mK, a compressibility of 15% to 30% at a pressure of 10 to 20 psi, and a thickness of 0.1 to 0.3 mm.

In a fifteenth example, there is provided the electronic device of the thirteenth example, wherein the second heat dissipation structure comprises a carbon-based conductive filler, and wherein the second heat dissipation structure has a thermal conductivity of 20 to 40 W/mK, a compressibility of 0.1% to 15% at a pressure of 10 to 20 psi, and a thickness of 0.1 to 0.3 mm.

In a sixteenth example, there is provided the electronic device of the thirteenth example, wherein the first heat dissipation structure comprises a ceramic-based filler.

In a seventeenth example, there is provided the electronic device of the thirteenth example, wherein the second heat dissipation structure comprises a carbon-based conductive filler.

In an eighteenth example, there is provided the electronic device of the thirteenth example, wherein the second heat dissipation structure is disposed over the electronic components, wherein the first heat dissipation structure is disposed over the second heat dissipation structure, and wherein the shielding film is disposed over the first heat dissipation structure.

In a nineteenth example, there is provided the electronic device of the thirteenth example, wherein at least a portion of the composite heat dissipation structure is disposed to cover an upper portion of at least some of the electronic components.

In a twentieth example, there is provided the electronic device of the thirteenth example, wherein at least a portion of the composite heat dissipation structure is disposed to cover an upper portion of all of the electronic components.

In a twenty-first example, there is provided a printed circuit board assembly (e.g. 401, 801, 901, 1001, 1101) comprising: a printed circuit board (e.g. 450) on which electronic components (e.g. 492, 494, 496, 498) are mounted; a shield can (e.g. 460) disposed to shield the electronic components; a composite heat dissipation structure (e.g. 402, 802, 902, 1002, 1102) disposed over the electronic components; and a shielding layer (e.g. 430) disposed over the composite heat dissipation structure.

In a twenty-second example, there is provided the printed circuit board assembly of the twenty-first example, wherein the composite heat dissipation structure comprises: a first heat dissipation structure (e.g. 470, 870, 970, 1070, 1170) comprising an insulating and compressible material; and a second heat dissipation structure (e.g. 480, 880, 980, 1080, 1180) comprising a conductive material.

In a twenty-third example, there is provided the printed circuit board assembly of the twenty-second example, wherein the first heat dissipation structure has a higher compressibility than the second heat dissipation structure.

In a twenty-fourth example, there is provided the printed circuit board assembly of the twenty-second or twenty-third examples, wherein the first heat dissipation structure has a lower thermal conductivity than the second heat dissipation structure.

In a twenty-fifth example, there is provided the printed circuit board assembly of any of the twenty-second to twenty-fourth examples, wherein the first heat dissipation structure comprises a ceramic-based filler.

In a twenty-sixth example, there is provided the printed circuit board assembly of any of the twenty-second to twenty-fifth examples, wherein the first heat dissipation structure has a thermal conductivity of 2 to 4 W/mK, a compressibility of 15% to 30% at a pressure of 10 to 20 psi, and a thickness of 0.1 to 0.3 mm.

In a twenty-seventh example, there is provided the printed circuit board assembly of any of the twenty-second to twenty-sixth examples, wherein the second heat dissipation structure comprises a carbon-based conductive filler.

In a twenty-eighth example, there is provided the printed circuit board assembly of any of the twenty-second to twenty-seventh examples, wherein the second heat dissipation structure has a thermal conductivity of 20 to 40 W/mK, a compressibility of 0.1% to 15% at a pressure of 10 to 20 psi, and a thickness of 0.1 to 0.3 mm.

In a twenty-ninth example, there is provided the printed circuit board assembly of any of the twenty-second to twenty-eighth examples, wherein a porous conductive adhesive material (e.g. 440) is disposed on a lower surface of the shielding layer.

In a thirtieth example, there is provided the printed circuit board assembly of any of the twenty-second to twenty-ninth examples, wherein the first heat dissipation structure is disposed over the electronic components, wherein the second heat dissipation structure is disposed over the first heat dissipation structure, and wherein the shielding layer is disposed over the second heat dissipation structure.

In a thirty-first example, there is provided the printed circuit board assembly of any of the twenty-second to twenty-ninth examples, wherein the second heat dissipation structure is disposed over the electronic components, wherein the first heat dissipation structure is disposed over the second heat dissipation structure, and wherein the shielding layer is disposed over the first heat dissipation structure.

In a thirty-second example, there is provided the printed circuit board assembly of any of the twenty-second to thirty-first examples, wherein the first heat dissipation structure is disposed to at least partially surround the second heat dissipation structure.

In a thirty-third example, there is provided the printed circuit board assembly of any of the twenty-second to thirty-second examples, wherein the first heat dissipation structure is formed with an air outlet (e.g. 810); wherein the air outlet is configured such that when pressure is applied in a direction perpendicular to the surface of the printed circuit board on which the electronic components are mounted, air present in an area surrounded by the first heat dissipation structure is discharged through the air outlet and the air outlet is closed.

In a thirty-fourth example, there is provided the printed circuit board assembly of any of the twenty-first to thirty-third examples, wherein at least a portion of the composite heat dissipation structure is disposed to cover an upper portion of at least some of the electronic components, or wherein at least a portion of the composite heat dissipation structure is disposed to cover an upper portion of all of the electronic components.

In a thirty-fifth example, there is provided an electronic device (e.g. 400) comprising the printed circuit board assembly of any of the of the twenty-first to thirty-fourth examples, wherein the electronic device (400) comprises: a display (e.g. 410) disposed on the shielding layer.

A printed circuit board assembly including the composite heat dissipation structure of the disclosure, and an electronic device including the printed circuit board assembly, may be configured such that a first heat dissipation structure (e.g., an insulating heat dissipation structure) is disposed to cover an upper surface of at least some of heat-generating components (e.g., a processor and a memory), and a second heat dissipation structure (e.g., a conductive heat dissipation structure) is disposed to cover at least a portion of a top surface of the first heat dissipation structure, thereby preventing the occurrence of a short circuit.

Since the composite heat dissipation structure according to an embodiment of the disclosure has different compressibilities between the first heat dissipation structure (e.g., the insulating heat dissipation structure) and the second heat dissipation structure (e.g., the conductive heat dissipation structure), it may be possible to prevent defects caused by compression during a manufacturing process.

The composite heat dissipation structure according to an embodiment of the disclosure applies a compressible TIM, thereby reducing thermal resistance at an interface between the heat-generating components (e.g., the processor and the memory) and the composite heat dissipation structure.

The printed circuit board assembly including the heat dissipation structure of the disclosure, and the electronic device including the printed circuit board assembly, may improve the heat dissipation performance of heat generated from the processor and the memory even under an environment where high heat generation of about 15 W occurs.

For example, as a result of comparing the dynamic thermal management (DTM) timing at which the maximum temperature is reached and the GPU temperature, the DTM timing may be delayed by about 54 to 58 seconds and the processor temperature may be reduced by about -5.8°C by applying the heat dissipation structure (#3) of the disclosure compared to the comparative examples (#1 and #2).

Advantageous effects obtainable from the disclosure may not be limited to the above-mentioned effects, and other effects which are not mentioned herein may be clearly understood from the following description by those skilled in the art to which the disclosure pertains.

## Claims

1. A printed circuit board assembly (401, 801, 901, 1001, 1101) comprising:
a printed circuit board (450) on which electronic components (492, 494, 496, 498) are mounted;
a shield can (460) disposed to shield the electronic components (492, 494, 496, 498);
a composite heat dissipation structure (402, 802, 902, 1002, 1102) disposed over the electronic components (492, 494, 496, 498); and
a shielding layer (430) disposed over the composite heat dissipation structure (402, 902, 1002, 1102).

2. The printed circuit board assembly (401, 801, 901, 1001, 1101) of claim 1, wherein the composite heat dissipation structure (402, 802, 902, 1002, 1102) comprises:
a first heat dissipation structure (470, 870, 970, 1070, 1170) comprising an insulating and compressible material; and
a second heat dissipation structure (480, 880, 980, 1080, 1180) comprising a conductive material.

3. The printed circuit board assembly (401, 801, 901, 1001, 1101) of claim 2, wherein the first heat dissipation structure (470, 870, 970, 1070, 1170) has a higher compressibility than the second heat dissipation structure (480, 880, 980, 1080, 1180).

4. The printed circuit board assembly (401, 801, 901, 1001, 1101) of claim 2 or 3, wherein the first heat dissipation structure (470, 870, 970, 1070, 1170) has a lower thermal conductivity than the second heat dissipation structure (480, 880, 980, 1080, 1180).

5. The printed circuit board assembly (401, 801, 901, 1001, 1101) of any of claims 2 to 4, wherein the first heat dissipation structure (470, 870, 970, 1070, 1170) comprises a ceramic-based filler.

6. The printed circuit board assembly (401, 801, 901, 1001, 1101) of any of claims 2 to 5, wherein the first heat dissipation structure (470, 870, 970, 1070, 1170) has a thermal conductivity of 2 to 4 W/mK, a compressibility of 15% to 30% at a pressure of 10 to 20 psi, and a thickness of 0.1 to 0.3 mm.

7. The printed circuit board assembly (401, 801, 901, 1001, 1101) of any of claims 2 to 6, wherein the second heat dissipation structure (480, 880, 980, 1080, 1180) comprises a carbon-based conductive filler.

8. The printed circuit board assembly (401, 801, 901, 1001, 1101) of any of claims 2 to 7, wherein the second heat dissipation structure (480, 880, 980, 1080, 1180) has a thermal conductivity of 20 to 40 W/mK, a compressibility of 0.1% to 15% at a pressure of 10 to 20 psi, and a thickness of 0.1 to 0.3 mm.

9. The printed circuit board assembly (401, 801, 901, 1001, 1101) of any of claims 2 to 8, wherein a porous conductive adhesive material (440) is disposed on a lower surface of the shielding layer (430).

10. The printed circuit board assembly (401, 801, 901, 1001, 1101) of any of claims 2 to 9, wherein the first heat dissipation structure (470, 870, 970, 1070, 1170) is disposed over the electronic components (492, 494, 496, 498),
wherein the second heat dissipation structure (480, 880, 980, 1080, 1180) is disposed over the first heat dissipation structure (470, 870, 970, 1070, 1170), and
wherein the shielding layer (430) is disposed over the second heat dissipation structure (480, 880, 980, 1080, 1180).

11. The printed circuit board assembly (401, 801, 901, 1001, 1101) of any of claims 2 to 9, wherein the second heat dissipation structure (480, 880, 980, 1080, 1180) is disposed over the electronic components (492, 494, 496, 498),
wherein the first heat dissipation structure (470, 870, 970, 1070, 1170) is disposed over the second heat dissipation structure (480, 880, 980, 1080, 1180), and
wherein the shielding layer (430) is disposed over the first heat dissipation structure (470, 870, 970, 1070, 1170).

12. The printed circuit board assembly (401, 801, 901, 1001, 1101) of any of claims 2 to 11, wherein the first heat dissipation structure (470, 870, 970, 1070, 1170) is disposed to at least partially surround the second heat dissipation structure (480, 880, 980, 1080, 1180).

13. The printed circuit board assembly (401, 801, 901, 1001, 1101) of any of claims 2 to 12, wherein the first heat dissipation structure (470, 870, 970, 1070, 1170) is formed with an air outlet (810);
wherein the air outlet (810) is configured such that when pressure is applied in a direction perpendicular to the surface of the printed circuit board (450) on which the electronic components (492, 494, 496, 498) are mounted, air present in an area surrounded by the first heat dissipation structure (470, 870, 970, 1070, 1170) is discharged through the air outlet (810) and the air outlet (810) is closed.

14. The printed circuit board assembly (401, 801, 901, 1001, 1101) of any of claims 1 to 13, wherein at least a portion of the composite heat dissipation structure (402, 802, 902, 1002, 1102) is disposed to cover an upper portion of at least some of the electronic components (492, 494, 496, 498), or
wherein at least a portion of the composite heat dissipation structure (402, 802, 902, 1002, 1102) is disposed to cover an upper portion of all of the electronic components (492, 494, 496, 498).

15. An electronic device (400) comprising the printed circuit board assembly (401, 801, 901, 1001, 1101) of any preceding claim, wherein the electronic device (400) comprises:
a display (410) disposed on the shielding layer (430).
